# EUROPEAN PATENT SPECIFICATION

(11) **EP 3 966 539 B1**
(45) Date of publication and mention of the grant of the patent: **10.07.2024**
(21) Application number: 20726523.2
(22) Date of filing: 07.05.2020
(51) Int. Cl.: G01L 1/16, G01L 1/18, G01L 1/20, G01L 5/22, B82Y 15/00, B82Y 40/00, G01N 33/00, B32B 7/12, H10N 30/00, H10N 30/30, B32B 27/12

(54) **SUBSTRATES COMPRISING NANOWIRES**
NANODRÄHTE ENTHALTENDE SUBSTRATE
SUBSTRATS COMPRENANT DES NANOFILS

(30) Priority: 08.05.2019 GB 201906499; 24.05.2019 GB 201907424
(43) Date of publication of application: 16.03.2022
(73) Proprietor: Wootzano Limited, Edinburgh EH2 4AD (GB)
(72) Inventor: SYED, Atif, Edinburgh EH2 4AD (GB); MASTROPAOLO, Enrico, Edinburgh EH2 4AD (GB); BECKWITH, Mark James, Edinburgh EH2 4AD (GB)
(74) Representative: Drywood, Rosalind Aerona
(86) International application number: PCT/GB2020/051124
(87) International publication number: WO 2020/225566

(56) References cited:
- WO-A1-2018/201181
- CN-A- 102 522 493
- US-A1- 2011 309 354
- US-A1- 2013 251 943
- US-A1- 2015 357 374
- US-A1- 2017 319 092

## Description

### Field of the Invention

The present invention relates to substrates for use in electronic skins, as well as the electronic skins themselves, and methods for making the same. In particular, the present invention relates to substrates and electronic skins which provide an enhanced sensory response.

### Background to the Invention

Electronic skins are intended to mimic the functionality of human skin. Thus, like human skin, an electronic skin should be flexible and stretchable. Crucially, electronic skins should provide a sensory response to different environments. This has made electronic skins an area of interest in a wide range of fields, including robotics, prosthetics and diagnostics.

Electronic skins typically comprise a base substrate and electronic components. The base substrate imparts the mechanical properties onto the electronic skin. The electronic components impart the sensory properties onto the electronic skin, e.g. conductive materials which provide a piezoresistive response under mechanical stress may be used as a force sensor.

Ideally, the base substrate is made of elastomeric polymer so that the electronic skin itself is flexible and strong. However, electronic components are typically rigid and unconformable which makes their integration into an ideally flexible electronic skin challenging.

This inherent incompatibility means that electronic skins have often been prepared using an inelastic polymer, e.g. having a Young's modulus of at least 300 MPa. These electronic skins are deformable and robust to a point, but beyond this point the substrate will not return to its original shape.

Where an elastomeric polymer is used in the base substrate, a thin layer of conductive material may be applied to its surface so that the mechanical properties of the base substrate are retained in the electronic skin. Whilst these electronic skins are highly conformable, the conductive material has a tendency to detach from the base polymer in places during use.

Thicker conductive layers are vulnerable to cracking and reduce the conformability of the electronic skin.

Accordingly, there is a need for substrates for use in an electronic skin which are stretchable and flexible, but which are sufficiently robust for the electronic skin to be reused without losing its functionality.

One way in which these problems have previously been addressed is by dispersing nanostructures through a polymer matrix. However, these electronic skins provide low and unpredictable sensory responses due to a lack of uniformity and alignment of the nanostructures. US 2017/319092 A1 relates to a flexible implantable electrode device having a polymeric carrier layer, an intermediate barrier layer and a conductive layer mounted on the intermediate layer, whereby the barrier layer may be made of parylene. US 2011/309354 A1 relates to methods of manufacturing arrays of vertically aligned ZnO nanowires on a substrate. US 2013/251943 A1 relates to fabrication methods and applications of nanowire-polymer composite electrodes, and more particularly to methods for fabricating flexible, transparent conductors utilizing conductive nanowires with a smooth active surface for use in electronic devices such as light emitting devices and solar cells. WO 2018/201181 A1 relates to an improved elastic electronic conductor suitable for electronic skins and wearable health monitors and to a method of fabricating such conductors. The elastic conductor comprises an elastomeric substrate, and an array of nanowires, such as gold nanowires, wherein the nanowires are standing relative to the surface of the substrate. US 2015/357374 A1 to a flexible transistor array used for pressure-sensing imaging and a manufacturing method thereof. Each of the transistor elements include a bottom electrode disposed on the substrate and a connection wire for the bottom electrode; a piezoelectric body disposed on the bottom electrode, wherein the piezoelectric body is made of piezoelectric material; and a top electrode disposed on the piezoelectric body. The piezoelectric body of each transistor element is formed of a nanowire or nanorod.

In some applications, it is also desirable for the sensory response of an electronic skin to be multifaceted. For instance, it might be desirable for an electronic skin to provide a sensory response to multiple environmental conditions, such as a response to temperature but also pressure. In other applications, it might be desirable for an electronic skin to provide a multiple sensory responses to a single environmental condition.

Sensory responses have been made more sophisticated by the introduction of gold and silver nanowires into electronic skins. For instance, Cheng at al. (Nanoscale, 2017, 9, 3834-3842) disclose the use of pre-cracked silver nanowire based fibres with helical microstructures as basic electrodes in an electronic skin to purportedly provide stretchability and strain sensing capability. Gong et al (Nanoscale Horiz., 2018, 3, 640-647) disclose a tactile electronic skin sensor based on staircase-like vertically aligned gold nanowires (V-AuNWs) which is said to mimic the skins ability to sense the location and sharpness of an object.

However, nanowire deposition often takes place at elevated temperatures and can lead to swelling of an elastomeric substrate. This can have a detrimental impact on the adhesion between the nanowires and the electronic skin.

Accordingly, there is a need for electronic skins which provide a sophisticated sensory response, and which are preferably stretchable, conformable and robust during use.

### Summary of the Invention

The present invention is based on the surprising discovery that the integrity of the bond between a conductive layer and a base polymer layer may be improved by the use of an intermediate polymer comprising electron-rich groups linked directly to one another, or by relatively short alkanediyl bridges, together in combination with one or more adhesive layers.

It is the rough surface of polymeric substrates, in particular elastomeric substrates, that is thought to compromise the integrity of the bond between the conductive layer and the base polymer layer in prior art substrates. Without wishing to be bound by theory, the electron-rich groups of the intermediate polymer are believed to lie relatively flat on the surface of the second adhesive therefore smoothing the surface of the base polymer layer. A relatively short alkanediyl bridge, or a direct linkage, between the electron-rich groups means that the intermediate polymer is afforded enough flexibility to contour to the surface of the base polymer layer, but not so much flexibility that the smoothing effect is compromised.

The detachment observed between a base polymer layer and a conductive layer can be exaggerated when nanowires are present. This is because deposition of nanowires typically occurs at elevated temperatures which cause the base polymer to swell. The use of an intermediate polymer layer and adhesive layers has been shown to improve the integrity of the bond between the conductive layer and the base substrate, even when nanowires have been applied.

Thus, the present invention provides a substrate for use in an electronic skin, said substrate comprising:
a base polymer layer;
a first intermediate polymer layer attached to the base polymer layer by a first adhesive layer, the first intermediate polymer layer comprising a first intermediate polymer in which electron-rich groups are linked directly to one another or by optionally substituted C₁₋₄ alkanediyl groups; and
a first conductive layer attached to the first intermediate polymer layer by a second adhesive or by multiple second adhesive layers between which a second intermediate polymer layer or a second conductive layer is disposed;
wherein nanowires are present on the first conductive layer.

The present invention also provides an electronic skin comprising the substrate.

Further provided are methods for preparing the substrate and the electronic skins of the present invention.

Methods in which the electronic skins may be used, are also provided.

### Brief Description of the Drawings

Figure 1 is a diagram of a method for preparing a substrate of the present invention.
Figure 2 shows X-ray diffraction patterns obtained from zinc nanowires on substrates of the present invention. Two different substrates were used: one with a polydimethylsiloxane base layer and one with a polyimide base layer.
Figures 3 and 4 show scanning electron microscopy (SEM) images of zinc nanowires on a substrate of the present invention. Specifically, Figure 3 shows images from a substrate having a polydimethylsiloxane base layer and Figure 4 shows images from a substrate having a polyimide base layer.
Figure 5 shows the results of a repeated bending test during which the conductivity of a zinc conductive layer of substrates of the present invention was monitored. Figure 5a shows the results from a substrate having a polydimethylsiloxane base layer and Figure 5b shows the results from a substrate having a polyimide base layer.
Figure 6 shows SEM images demonstrating the superior bonding that is observed in substrates of the present invention as compared to prior art substrates. Specifically, Figure 6a shows an SEM image of a substrate of the present invention in which a first intermediate polymer layer and a second adhesive layer were used, while Figure 6b shows an SEM image of a substrate in which the first intermediate polymer layer and the second adhesive layer were not used.
Figure 7 is a diagram of a method for preparing a substrate of the present invention in which a top electrode has been added to zinc oxide nanowires so that a piezoelectric response may be measured.
Figure 8 shows a nanowire-covered substrate which has been functionalised with binding groups.
Figure 9 shows graphs of the changes in electrical resistance caused by physioabsorption of a protein onto different substrates.

### Detailed Description of the Invention

The present invention provides a substrate for use in an electronic skin. The substrate comprises a base polymer layer, a first intermediate polymer layer which is attached to the base polymer layer by a first adhesive layer, and a first conductive layer which is attached to the first intermediate polymer layer by a second adhesive layer or by multiple second adhesive layers between which a second intermediate polymer layer or a second conductive layer is disposed. Nanowires are present on the first conductive layer. Since the substrate is for use in an electronic skin, it will typically be flexible and stretchable.

### Base polymer layer

The base polymer layer comprises a base polymer, which is preferably an elastomer. Elastomers are well-known in the art as polymers that display rubber-like elasticity.

The base polymer may be selected from polysiloxanes, polyimides (PI), polybutyrates (PBAT), polymethyl methacrylates (PMMA), polyacrylic acids, polyethylenes (PE) e.g. high density polyethylenes (HDPE) and low density polyethylenes (LDPE), polyethylene terephthalates (PET), polyurethanes (PU) including thermoplastic polyurethanes (TPU), polyvinyl chlorides (PVC), polyethylenimines (PEI), polyethylene naphthalates (PEN), polypropylenes (PP), polystyrenes (PS), polyamides including aliphatic or semi-aromatic polyamides, polytetrafluoroethylenes (PTFE), and polyvinylidene difluorides (PVDF).

Preferred base polymers include polysiloxanes, polyimides, polybutyrates, polymethyl methacrylates, polyethylenes e.g. high density polyethylene and low density polyethylene, polyethylene terephthalates, polyvinyl chlorides, polyethylenimines, polyethylene naphthalates, and polypropylenes. These polymers are particularly suitable for forming a base polymer layer which is highly flexible. Particularly preferred are polysiloxanes and polyimides.

Polysiloxanes are polymers with a backbone of alternating silicon and oxygen atoms. Preferred polysiloxanes have the structure: 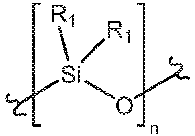 where: each R₁ is independently selected from hydrogen, alkyl and phenyl groups, preferably from hydrogen and C₁₋₆ alkyl groups, more preferably from hydrogen, methyl (i.e. -CH₃), ethyl (i.e. -CH₂CH₃) and propyl (i.e. -CH₂CH₂CH₃ or -CH(CH₃)CH₃), still more preferably from hydrogen and methyl.

It will be appreciated that a variety of siloxane monomers may be used in the polysiloxane or, in other words, the R₁ groups may differ between the monomers making up the polysiloxane.

Preferred polysiloxanes comprise at least 50 molar %, preferably at least 80 molar %, and more preferably at least 85 molar % of monomers in which each R₁ is methyl. Preferably, the polysiloxane is a polydimethylsiloxane.

Polyimides may take a range of structures provided that the imide monomers from which the polymer is prepared include the imide (i.e. -C(O)-NR-C(O)-) functional group. Preferred polyimides include poly(4,4'-oxydiphenylene-pyromellitimide) (e.g. Kapton^{®}): 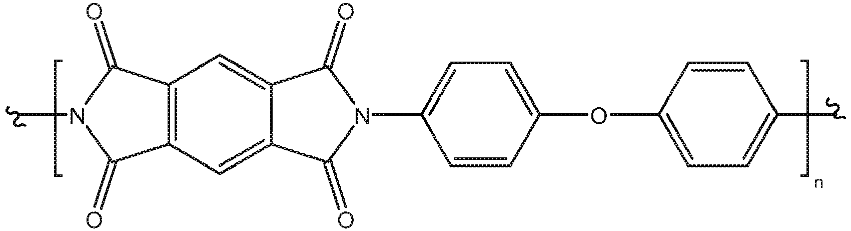 or, more preferably, a structure selected from: 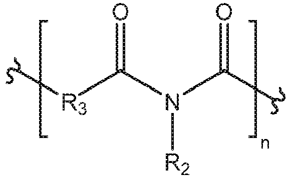 where:
R₂ is an alkyl group, preferably a C₁₋₆ alkyl groups, more preferably is methyl (*i.e*. -CH₃), ethyl (*i.e*. -CH₂CH₃) or propyl (*i.e*. -CH₂CH₂CH₃ or -CH(CH₃)CH₃), and most preferably is methyl, and
R₃ is an alkanediyl group, preferably a C₁₋₆ alkanediyl (*i.e*. alkanediyl) group, more preferably is methanediyl (*i.e*. -CH₂-), ethanediyl (*i.e*. -CH₂CH₂-) or propanediyl (*i.e*. -CH₂CH₂CH₂- or -CH(CH₃)CH₂-), and most preferably is methanediyl.

Polysiloxanes are preferably used as the base polymer, as these materials are flexible, stretchable and bendable making them highly robust in a wide range of applications.

The base polymer may be made up of a blend of polymers, for instance a blend of the base polymers listed above, though preferably it will consist of a single polymer such as a polysiloxane.

The base polymer may have a Young's modulus of up to 5 MPa, preferably up to 3 MPa, and more preferably up to 2 MPa. The base polymer may have a Young's modulus of at least 200 kPa, preferably at least 350 kPa and more preferably at least 500 kPa. Thus, the base polymer may have a Young's modulus of from 200 kPa to 5 MPa, preferably from 350 kPa to 3 MPa, and more preferably from 500 kPa to 2 MPa.

The base polymer may have a number average molecular weight of at least 7,500 Da, preferably at least 15,000 Da, and more preferably at least 20,000 Da. The base polymer may have a number average molecular weight of up to 200,000 Da, preferably up to 150,000 Da, and more preferably up to 100,000 Da. Thus, the base polymer may have a number average molecular weight of from 7,500 to 200,000 Da, preferably from 15,000 to 150,000 Da, and more preferably from 20,000 to 100,000 Da. Polymers having these molecular weights will typically exhibit preferred levels of elasticity.

It will be appreciated that the base polymers will typically be electrical insulators, e.g. they will meet the requirements of ASTM D5213-12.

The base polymer layer may comprise the base polymer in an amount of at least 75 %, preferably at least 80 %, and more preferably at least 85 %, by weight.

Preferably, the base polymer layer comprises a cross-linking agent. A wide range of cross-linking agents may be used, with siloxanes such as methyl hydrogen siloxane preferred. The cross-linking agent may be present in the base polymer in an amount of up to 15 %, and preferably up to 10 %, by weight. Other components that may be present in the base polymer layer include dyes.

The base polymer layer will typically have a thickness of less than 5 mm. The base polymer layer may have a thickness of up to 2 mm, preferably up to 1.5 mm, and more preferably up to 1 mm. The base polymer layer may have a thickness of at least 500 µm. Thus, the base polymer layer may have a thickness of from 500 µm to 2 mm, preferably from 500 µm to 1.5 mm, and more preferably from 500 µm to 1 mm. In some embodiments, the base polymer layer will have a thickness of about 500 µm. Base polymer layers of this thickness exhibit excellent flexibility, yet are sufficiently robust when used in an electronic skin. In some instances where a more robust substrate is preferred, *e.g*. where the electronic skin is to be used against rough surfaces such as the ground, the base polymer layer may have, in its most preferred form, a thickness of from 750 µm to 1 mm.

It will be appreciated that that the thicknesses referred to above represent the minimum and maximum thicknesses observed in the base polymer layer, *i.e.* a thickness of from A to B means that the minimum thickness of the layer is at least A and the maximum thickness of the layer is up to B. The thickness of the base polymer layer may be measured using scanning electron microscopy. Specifically, scanning electron microscopy may be used to generate images of the base polymer layer, with the thickness preferably determined using a computer program.

### First adhesive layer

The first adhesive layer improves the bond between the base polymer layer and the first intermediate polymer layer. It will be appreciated that the term 'adhesive layer' does not encompass a junction at which two materials are directly bonded together (*e.g*. by a bonding technique like plasma bonding), but rather requires an adhesive to be present so that the two materials are indirectly bonded together and separated by the adhesive.

Typically, the first adhesive used in the first adhesive layer will contain a head group which is capable of bonding, preferably via a covalent bond, to the base polymer and an end group which is capable of bonding, preferably via a covalent bond, to the first intermediate polymer. This enables the adhesive to bond the layers together. It will be appreciated that further functional groups (*i.e*. groups other than those consisting of hydrogen atoms and saturated carbon atoms) may be present in the first adhesive, though generally the adhesive will contain only two functional groups namely the head group and the end group.

A wide range of functional groups may be used as the head and end groups in the first adhesive. The preferred functional groups will in part depend on the composition of the base polymer layer and the first intermediate polymer layer. The head and end groups that may be used in the first adhesive may be independently selected from: sulfur-containing, silicon-containing, nitrogen-containing, oxygen-containing, phosphorus-containing and boron-containing groups.

Preferably, the head and end groups in the first adhesive may be independently selected from thiol (-SH), alkoxysilanes (-Si(R^{a})ₓ(OR^{a})₃₋ₓ), where x is 0-2, preferably 0), phosphonates (-P(O)(OR^{a})₂), hydroxy (-OH), carboxy (-C(O)OH), amino (-NH₂), amide (-C(O)NH₂) where each R^{a} is independently selected from hydrogen and alkyl groups, preferably C₁₋₃ alkyl groups, and more preferably is methyl. More preferably, the head and end groups may be independently selected from thiol and alkoxysilanes. In a particularly preferred embodiment, the head group is -Si(OMe)₃ and the end group is -SH.

The head and end groups are joined in the first adhesive via a linking group, L, which is preferably an alkyl group. Preferably, the linking group is a C₁₋₁₀ alkyl group, more preferably a C₁₋₆ alkyl group, and still more preferably a C₂₋₄ alkyl group. Preferably, the linking group is a straight-chain alkyl group. Though less preferred, other linking groups such as ethers or polyethers may also be used.

Thus, preferred first adhesives have the structure: 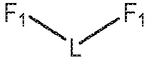 where:
each F₁ is independently selected from functional groups, such as those listed above, and
L is selected from linking groups, such as those described above.

(3-Mercaptopropyl)trimethoxysilane is particularly preferred for use as the first adhesive. This adhesive is particularly effective at joining a siloxane base polymer layer with a poly(xylylene) first intermediate polymer layer.

The first adhesive layer may comprise a mixture of adhesives, such as a mixture of the first adhesives described above, though preferably it will contain just a single adhesive. The first adhesive layer preferably comprises the first adhesive in an amount of at least 90 %, preferably at least 95 %, and more preferably at least 99 % by weight.

The first adhesive will preferably be in the form of a monolayer, and more preferably a self-assembled monolayer. (3-Mercaptopropyl)trimethoxysilane is particularly suitable for forming a self-assembled monolayer.

The first adhesive layer may have a thickness of up to 10 nm, preferably up to 5 nm, and more preferably up to 1 nm. The first adhesive layer may have a thickness of at least 0.1 nm, preferably at least 0.25 nm and more preferably at least 0.5 nm. Thus, the first adhesive layer may have a thickness of from 0.1 to 10 nm, preferably from 0.25 to 5 nm, and more preferably from 0.5 to 1 nm.

It will be appreciated that that the thicknesses referred to above represent the minimum and maximum thicknesses observed in the first adhesive layer. Thus, a thickness of from A to B means that the minimum thickness of the layer is at least A and the maximum thickness of the layer is up to B. The thickness of the first adhesive layer may be measured using atomic force microscopy. Specifically, atomic force microscopy may be used to generate images of the first adhesive layer, with the thickness preferably determined using a computer program.

### First intermediate polymer layer

The first intermediate polymer layer sits directly on top of the first adhesive.

The first intermediate polymer used in the first intermediate polymer layer comprises electron-rich groups linked directly to one another or by optionally substituted C₁₋₄ alkanediyl groups. Preferred first intermediate polymers have the structure: 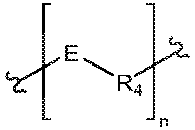 where:
E is selected from electron-rich groups, and
R₄ is selected from C₁₋₄ alkanediyl, optionally substituted with one or more halide groups, or is absent.

As mentioned above, it is believed that the electron-rich groups lie relatively flat on the surface of the base polymer layer therefore smoothing its surface.

A group will be considered electron rich provided that all of the atoms which form part of the polymer backbone form part of a double or triple bond, or have a lone pair of electrons.

Electron-rich groups must have at least 2, but preferably at least 3, and more preferably at least 4, atoms in the polymer backbone. Electron-rich groups may have up to 10, preferably up to 7, and more preferably up to 5 atoms in the polymer backbone. Thus, electron-rich groups may have from 2 to 10, preferably from 3 to 7, and more preferably from 4 to 5 atoms in the polymer backbone. Where multiple electron-rich paths may be taken along a polymer backbone in the electron-rich group, the number of atoms in the shorter path are considered, so for instance the electron-rich groups in poly(*meta*-xylylene) would be considered to have 3, rather than 5, atoms in the polymer backbone.

The electron-rich group, E, is preferably a conjugated group. As is standard in the art, a conjugated group can be represented as alternating single and multiple (*e.g*. double or triple) bonds, such that conjugation occurs across the group. Since conjugation is the interaction of a p-orbital from one double bond with a p-orbital from another double bond across an intervening single bond, the conjugated group must contain at least two multiple bonds and it must start and end with a multiple bond, *i.e*. the bridging alkanediyl group, R₄, must be bonded to an atom which forms part of a multiple bond.

Suitable conjugated groups may be selected from aromatic groups, and more preferably from C₆₋₁₀ aromatic hydrocarbon and C₅₋₁₀ heteroaromatic groups. Where the conjugated group is heteroaromatic, one or more of the ring members is a heteroatom, *e.g*. selected from O, N and S, though preferably no more than two and more preferably no more than one of the ring atoms is a heteroatom. Particularly preferred conjugated groups are selected from optionally substituted benzene groups.

The conjugated group may be unsubstituted or substituted with one or more groups selected from -R^{b}X, where R^{b} is selected from C₁₋₃ alkanediyl groups or is absent, and X is selected from -Cl, -Br, -I, -F, -CF₃, -C=CH, -CN, -NH₂ and -OH. R^{b} is preferably selected from ethanediyl, methanediyl or is absent, and more preferably is absent.

Preferably, the conjugated group is substituted with one or more groups selected from -Cl, -Br, -F, -C≡CH, -NH₂ and -CH₂NH₂ or is unsubstituted.

Other electron-rich groups that may be used in the first intermediate polymer include -C(O)-NR- and -C(O)-NR-C(O)-.

The electron-rich groups in the first intermediate polymer are directly linked or preferably bridged by R₄, a C₁₋₄ alkanediyl group optionally substituted with one or more halide groups. By using a relatively short alkanediyl bridge between the electron-rich groups, the first intermediate polymer is afforded enough flexibility to contour to the surface of the base polymer layer, but not so much flexibility that the smoothing effect is compromised.

Preferably, R₄ is selected from optionally substituted C₂₋₃ alkanediyl groups, more preferably from ethanediyl optionally substituted with two to four groups selected from -F and -Cl, still more preferably from ethanediyl, -CHF-CHF- and -CF₂-CF₂-. More preferably, the electron-rich groups are bridged by ethanediyl.

Preferred first intermediate polymers are selected from poly(xylylenes) in which the phenyl ring and methylene bridge are optionally substituted. Particularly preferred are poly(*para-*xylenes) in which the phenyl ring is preferably substituted with 1 or 2, and more preferably 1, chloride groups. These polymers have the structure:

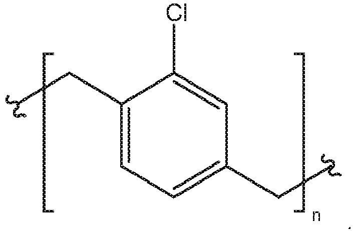

It will be appreciated that the position of the chlorine atom on the phenyl ring may vary between repeating units.

Preferably, the first intermediate polymer is selected from parylenes, *i.e*. optionally substituted poly(*para*-xylenes) which have been vapour deposited. Particularly preferred is parylene C, which has a single chlorine atom on each phenyl ring, as shown above.

The first intermediate polymer may be made up of a blend of polymers, for instance a blend of the first intermediate polymers described above, though preferably it will consist of a single intermediate polymer.

The first intermediate polymer preferably has a Young's modulus which is greater than that of the base polymer. It is believed that the higher Young's modulus contributes to the smoothing effect of the first intermediate polymer on the base polymer layer. The first intermediate polymer may have a Young's modulus which is at least 100 kPa, preferably at least 250 kPa and more preferably at least 500 kPa higher than that of the base polymer.

The first intermediate polymer may have a Young's modulus of at least 1 MPa, preferably at least 2 MPa and more preferably at least 3 MPa. The first intermediate polymer may have a Young's modulus of up to 5 GPa, preferably up to 4 GPa, and more preferably up to 3 GPa. Thus, the first intermediate polymer have a Young's modulus of from 1 MPa to 5 GPa, preferably from 2 MPa to 4 GPa, and more preferably from 3 MPa to 3 GPa.

It will be appreciated that, as with the base polymers, the first intermediate polymers will typically be electrical insulators, *e.g*. they will meet the requirements of ASTM D5213-12.

The first intermediate polymer layer will typically contain the first intermediate polymer in an amount of at least 90 %, preferably at least 95 %, and more preferably at least 99 %, by weight.

The first intermediate polymer layer preferably has a thickness which is less than that of the base polymer layer. The first intermediate polymer layer may have a thickness which is up to 0.5, preferably up to 0.25, and more preferably up to 0.15, times the thickness of the base polymer layer.

The first intermediate polymer layer is preferably in the form of a thin film.

The first intermediate polymer layer may have a thickness of up to 10 µm, preferably up to 1 µm, and more preferably up to 750 nm. The first intermediate polymer layer may have a thickness of at least 10 nm, preferably at least 100 nm, and more preferably at least 250 nm. Thus, the first intermediate polymer layer may have a thickness of from 10 nm to 10 µm, preferably from 100 nm to 1 µm, and more preferably from 250 to 750 nm. First intermediate polymer layers of this thickness are suitable for smoothing the surface of the base polymer layer, without significantly modifying the tensile properties of the substrate.

It will be appreciated that that the thicknesses referred to above represent the minimum and maximum thicknesses observed in the first intermediate polymer layer, *i.e*. a thickness of from A to B means that the minimum thickness of the layer is at least A and the maximum thickness of the layer is up to B. The thickness of the first intermediate polymer layer may be measured using atomic force microscopy. Specifically, atomic force microscopy may be used to generate images of the first intermediate polymer layer, with the thickness preferably determined using a computer program.

### Second adhesive layer

The second adhesive layer(s) improve the bond between the first intermediate polymer layer and the first conductive layer.

Typically, the second adhesive used in the second adhesive layer or each of the second adhesive layers will contain a head group which is capable of bonding, preferably via a covalent bond, to an intermediate polymer layer and an end group which is capable of bonding, preferably via a covalent bond, to the first conductive layer. This enables the adhesive to bond the layers together. It will be appreciated that further functional groups (*i.e*. groups other than those consisting of hydrogen atoms and saturated carbon atoms) may be present in the second adhesive, though generally the adhesive will contain only two functional groups namely the head group and the end group.

A wide range of functional groups may be used as the head and end groups in the second adhesive. The preferred functional groups will in part depend on the composition of the intermediate polymer layer(s) and the first conductive layer. The head and end groups that may be used in the second adhesive may be independently selected from: sulfur-containing, silicon-containing, nitrogen-containing, oxygen-containing, phosphorus-containing and boron-containing groups.

Preferably, the head and end groups in the second adhesive may be independently selected from thiol (-SH), alkoxysilanes (-Si(R^{a})ₓ(OR^{a})₃₋ₓ, where x is 0-2, preferably 0), phosphonates (-P(O)(OR^{a})₂), hydroxy (-OH), carboxy (-C(O)OH), amino (-NH₂) and amide (-C(O)NH₂) groups, where each R^{a} is independently selected from hydrogen and alkyl groups, preferably C₁₋₃ alkyl groups, and more preferably is methyl. More preferably, the head and end groups may be independently selected from thiol and alkoxysilanes. In a particularly preferred embodiment, the head group is -Si(OMe)₃ and the end group is -SH.

The head and end groups are joined in the second adhesive via a linking group, L, which is preferably an alkyl group. Preferably, the linking group is a C₁₋₁₀ alkyl group, more preferably a C₁₋₆ alkyl group, and still more preferably a C₂₋₄ alkyl group. Preferably, the linking group is a straight-chain alkyl group. Though less preferred, other linking groups such as ethers or polyethers may also be used.

Thus, preferred second adhesives have the structure: 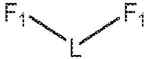 where:
each F₁ is independently selected from functional groups, such as those listed above, and
L is a linking group, such as that described above.

(3-Mercaptopropyl)trimethoxysilane is particularly preferred for use as the second adhesive. This adhesive is very effective at joining a poly(xylylene) intermediate polymer layer with a metallic conductive material.

The second adhesive may comprise a mixture of adhesives, such as a mixture of the second adhesives described above, though preferably it will contain just a single adhesive. The second adhesive layer or each of the second adhesive layers preferably comprises the second adhesive in an amount of at least 90 %, preferably at least 95 %, and more preferably at least 99 % by weight.

The second adhesive will generally be the same as the first adhesive, though they may also be different.

The first conductive layer may be attached to the first intermediate polymer layer by a second adhesive layer.

However, in some embodiments, multiple second adhesive layers may be used with a second intermediate polymer layer or a second conductive layer disposed between each of the second adhesive layers. These embodiments are preferred when the electrical contacts for the active portion are not present in the first conductive layer, since the second conductive layer(s) may provide the substrate with the electrical contacts and electrical vias connecting the electrical contacts to the active portion in the first conductive layer. The second conductive layer(s) may also be used in a substrate which comprises two active portions: the first active portion as part of the first conductive layer and the second active portion as part of a second conductive layer. Since the first conductive layer comprises nanowires, the first active portion may provide a piezoelectric sensory response while the second conductive layer may provide a piezoresistive sensory response.

It will be appreciated that - since a second intermediate polymer layer or a second conductive layer is disposed between each of the second intermediate polymer layers - where there are n+1 second intermediate polymer layers, a total of n second intermediate polymer layers and second conductive layers will be present. Thus, two second adhesive layers are used where a single second intermediate polymer layer is present, three second adhesive layers are used where two second intermediate polymer layers are present or where a single second intermediate polymer layer and a single second conductive layer are present, and so on.

Where multiple second adhesive layers are used, the layers disposed between the multiple second adhesive layers preferably alternate between a second conductive layer and a second intermediate polymer layer. This is so that the second intermediate polymer layer may electrically insulate the conductive layers from one another (though it will be appreciated that electrical vias, *e.g.* those passing vertically through the substrate, may be intended to electrically connect the conductive layers to one another). A second conductive layer is preferably attached to the first intermediate polymer by a second adhesive layer. A second intermediate polymer layer is preferably attached to the first conductive layer by a second adhesive.

Typically, the same second adhesive will be used in each of the multiple second adhesive layers.

The structure and composition of the second intermediate polymer layer or layers are preferably as described in connection with the base polymer layer or, more preferably, the first intermediate polymer layer. The second intermediate polymer layer or layers may have a thickness which is as described in connection with the first intermediate polymer layer. Preferably, the first and second intermediate polymer layers have the same composition.

The second conductive layer or layers may comprise a variety of conductive materials, such as those described below in connection with the first conductive layer. The second conductive layer or layers may have a thickness which is as described in connection with the first conductive layer. However, the surface shape of the second conductive layer or layers may differ from that of the first conductive layer. For instance, electrical contacts and vias will have a very different surface configuration - typically being smaller - than the active portion in the first conductive layer.

The second adhesive layer or each of the second adhesive layers will preferably be in the form of a monolayer, and preferably a self-assembled monolayer. (3-Mercaptopropyl)trimethoxysilane is particularly suitable for forming a self-assembled monolayer.

The second adhesive layer or each of the second adhesive layers may have a thickness of up to 10 nm, preferably up to 5 nm, and more preferably up to 1 nm. The second adhesive layer or each of the second adhesive layers may have a thickness of at least 0.1 nm, preferably at least 0.25 nm and more preferably at least 0.5 nm. Thus, the second adhesive layer or each of the second adhesive layers may have a thickness of from 0.1 to 10 nm, preferably from 0.25 to 5 nm, and more preferably from 0.5 to 1 nm.

It will be appreciated that that the thicknesses referred to above represent the minimum and maximum thicknesses observed in the second adhesive layer, *i.e.* a thickness of from A to B means that the minimum thickness of the layer is at least A and the maximum thickness of the layer is up to B. The thickness of the second adhesive layers may be measured using the method described above in connection with the first adhesive layer.

### First conductive layer

The first conductive layer sits on top of a second adhesive layer. Due to the smoothing effect of the first intermediate polymer layer, a high level of first conductive layer adhesion and robustness is achieved during use. It will be appreciated that the first conductive layer is not necessarily the lowest conductive portion in the substrate since one or more second conductive layers may sit below the first conductive layer in the substrate.

The first conductive layer is responsive to the environment, thereby providing the electronic skin with its sensory properties. Preferably, the first conductive layer comprises a material which is piezoresistive. Piezoresistive materials exhibit changes in their resistivity under mechanical stress, such as pressure. Since the change in piezoresistive response is proportional to the degree of mechanic stress that is applied to a piezoresistive material, the first conductive layer may be used to measure the force to which the electronic skin is subjected.

The first conductive layer may comprise a variety of conductive materials, such as metallic conductive materials or non-metallic conductive materials.

Preferably the conductive material is metallic. Metallic conductive materials may comprise a metal selected from zinc, aluminium, copper, silver, platinum, chromium, tungsten, titanium or iron. More preferably, the first conductive layer comprises zinc.

The metal may be present in the first conductive layer in the form of an elemental metal, a metal alloy or a metal oxide. Preferably, the conductive material comprises or, more preferably, consists of a material selected from elemental metals and metal oxides, for instance a material selected from zinc oxide (*e.g.* ZnO), iron oxide (*e.g.* Fe₂O₃), titanium oxide (*e.g*. TiO₂), metallic zinc, metallic silver, and combinations thereof.

Suitable non-metallic materials include conductive carbon materials, such as graphene or graphite, and conductive polymers.

The first conductive layer may comprise a mixture of conductive materials, such as a mixture of the conductive materials described above. For instance, the conductive material may comprise a mixture of an elemental metal and a metal oxide.

In some instances, the first conductive layer may comprise a first metallic layer and a second metallic layer. The first metallic layer may serve to enhance adhesion of the second metallic layer to the second adhesive layer, whilst still being conductive itself. The first metallic layer will typically be thinner than the second metallic layer, *e.g.* less than less than 10 %, and preferably less than 5 % of the thickness of the second metallic layer. Titanium may be used as the first metallic layer, particularly where aluminium is used as the second metallic layer.

The first conductive layer may be functionalised, *i.e*. the chemical nature of the first conductive layer altered. For instance, the surface of the first conductive layer may be functionalised. The first conductive layer may be functionalised with a binder, a catalyst, a reagent or any other species which enhances the sensory, *e.g.* piezoresistive, response of the electronic skin when it comes into contact with a target species. The magnitude of the sensory response may indicate the concentration of target species.

For instance, the first conductive layer may be functionalised with a functional group. A wide range of functional groups may be used, and suitable functional groups will be dependent on both the material of first conductive layer and the target species. Suitable functional groups include amino (-NH₂), hydroxy (-OH), carboxy (-COOH), amido (-CONH₂) and sulfanyl (-SH) groups. Preferably, the functional group is selected from amino (-NH₂), hydroxy (-OH) and sulfanyl (-SH) groups. These functional groups are useful as binders for target species. As shown in the examples, in a specific embodiment, the first conductive layer may be functionalised with amino groups for the detection of a protein target species, such as BSA (bovine serum albumin).

Where the first conductive layer is functionalised with a catalyst, this may cleave a target species into sub-sections, with one of the sub-sections inducing a sensory response in the electronic skin.

The first conductive layer may have a thickness of at least 10 nm, preferably at least 25 nm, and more preferably at least 50 nm. The first conductive layer may have a thickness of up to 300 nm, preferably up to 200 nm, and more preferably up to 100 nm. Thus, the first conductive layer may have a thickness of from 10 to 300 nm, preferably from 25 to 200 nm, and more preferably from 50 to 100 nm.

It will be appreciated that that the thicknesses referred to above represent the minimum and maximum thicknesses observed in the first conductive layer, *i.e.* a thickness of from A to B means that the minimum thickness of the layer is at least A and the maximum thickness of the layer is up to B. The thickness of the first conductive layer may be measured using atomic force microscopy. Specifically, atomic force microscopy may be used to generate images of the first conductive layer, with the thickness preferably determined using a computer program.

The first conductive layer preferably does not extend to the edges of the substrate.

The first conductive layer (or, where the first conductive layer comprises a plurality of discrete conductive portions as explained in detail below, each of the discrete conductive portions) will typically comprise an active portion. The active portion and nanowires provide the electronic skin with its sensory functionality.

Preferably, the surface of the active portion has a size of at least 500 nm, preferably at least 1 µm, and more preferably at least 10 µm, in all directions. The surface of the active portion may have a size of up to 500 µm, preferably up to 100 µm, and more preferably up to 45 µm, in all directions. Thus, the surface of the active portion may have a size of from 500 nm to 500 µm, preferably from 1 µm to 100 µm, and more preferably from 10 µm to 45 µm, in all directions.

It will be appreciated that that the surface sizes referred to above represent the minimum and maximum surface size observed in the first conductive layer, *i.e*. a size of from A to B means that the minimum size of the layer is at least A and the maximum size of the layer is up to B. In other words, the boundary of the active portion would wholly encompass a circle with diameter A but be wholly encompassed by a circle with diameter B.

So that a response, *e.g.* a piezoresistive or piezoelectric response, may be measured in the electronic skin, a pair (*i.e*. two) electrical contacts must be electrically connected to the active area. The two electrical contacts may be placed anywhere around the active portion provided that they are only electrically connected to one another via the active portion. The two electrical contacts may be attached to opposite sides of the active portion to one another. This maximises the area over which a response is measure.

The electrical contacts may form part of the first conductive layer. However, in other embodiments, the first conductive layer comprises the active portion, but the pair of electrical contacts is present in a different layer of the substrate, *e.g*. in a second conductive layer between the first intermediate polymer layer and the second adhesive layer to which the first conductive layer is attached. Where the electrical contacts form part of the first conductive layer, then the active portion and electrical contacts will generally have the same composition. However, where the electrical contacts are present in a second conductive layer, they may have a different composition from the first conductive layer active portion.

As discussed in below in the section on nanowires, the electrical contacts may also be electrically connected to one another via the nanowires.

In some applications, it may be desirable to use one or more further pairs of electrical contacts. For instance, the substrate, *e.g*. as part of the first conductive layer, may comprise a second pair of electrical contacts which are attached to the first conductive layer orthogonally to a first pair of electrical contacts.

The one or more further pairs of electrical contacts may be used to measure the same response as the first pair of electrical contacts, *e.g.* piezoresistive response, but across a different traverse of the active portion. However, preferably, the one or more further pairs of electrical contacts may be used to measure a different response in the active portion from that measured by the first pair of electrical contacts. For instance, a first pair of electrical contacts may be used to measure a piezoresistive response, and a second pair of electrical contacts may be used to measure a piezoelectric response.

Preferably, the first conductive layer comprises a plurality of discrete conductive portions which are electrically isolated from one another. The first conductive layer may comprise at least 4, preferably at least 25 and more preferably at least 100 discrete conductive portions. This enables a sensory response to be provided from each of the discrete conductive portions when used in an electronic skin.

The discrete conductive portions may be arranged as a matrix to form a unit cell on the substrate, *e.g.* a square matrix containing for instance 2×2, 3x3, 4×4, *etc.* discrete conductive portions, or a rectangular matrix containing for instance 2x3, 2×4, 3x4, etc. discrete conductive portions.

A unit cell may have a length and width of at least 500 µm, preferably at least 1 mm, and more preferably at least 5 mm. A unit cell may have a length and width of up to 100 mm, preferably up to 50 mm, and more preferably up to 15 mm. Thus, a unit cell may have a length and width of from 500 µm to 100 mm, preferably from 1 mm to 50 mm, and more preferably from 5 mm to 15 mm. Typically, the unit cells will be square so the length and width will be the same.

The discrete conductive portions in a unit cell will typically have the same shape.

The discrete conductive portions may be spaced at intervals of at least 1 µm, preferably at least 10 µm, and more preferably at least 25 µm, in a unit cell. The discrete conductive portions may be spaced at intervals of up to 1 mm, preferably up to 200 µm, and more preferably up to 75 µm, in a unit cell. Thus, the discrete conductive portions may be spaced at intervals of from 1 µm to 1 mm, preferably from 10 µm to 200 µm, and more preferably from 25 µm to 75 µm, in a unit cell. These intervals are particularly preferred since they represent typical intervals between mechanoreceptors on human skin. It will be appreciated that the interval spacing represents the distance from a location on the surface of a discrete conductive portion to the corresponding location on the surface of a neighbouring conductive portion in the matrix.

The substrate may comprise a plurality of unit cells. For instance, the substrate may comprise at least 3, or at least 5 or at least 10 unit cells. In some instances, the substrate may be provided as a grid of, preferably abutting, unit cells. The substrate is preferably adapted so that a portion of the unit cells may be separated from the grid. For instance, the boundaries of the unit cells may be marked or perforated to enable one or more of the unit cells to be separated from the grid by cutting or tearing.

### Nanowires

Nanowires are present on the first conductive layer in the substrates of the present invention. The use of nanowires enhances the sensory response that is provided an electronic skin. Typically, nanowires will be present on the active portion, and preferably just the active portion, of the first conductive layer.

The nanowires may comprise a material which is piezoelectric. Piezoelectric materials produce an electrical charge under mechanical stress, such as pressure.

Preferably, the nanowires comprise a conductive material, and preferably a metallic conductive material, though non-metallic conductive materials may also be used. Metallic conductive materials may comprise a metal selected from zinc and silver. More preferably, the metallic conductive material comprises zinc.

The metal may be present in the metallic conductive material in the form of an elemental metal, a metal alloy or a metal oxide. Preferably, the metallic conductive material comprises or, more preferably, consists of a material selected from elemental metals and metal oxides, and most preferably metal oxides. Zinc oxide is particularly suitable.

Preferably the metallic conductive material is in a crystalline form. The presence of a crystalline form may be confirmed using X-ray diffraction.

Preferably, the nanowires extend away from the surface of the first conductive layer, *i.e*. in the direction away from the polymer base layer. Preferably, a first end of the nanowires is tethered to the first conductive layer, with a second end generally not tethered to the first conductive layer (though, as will become apparent from the description below, the second end of the nanowires may be tethered to a third conductive layer).

The nanowires may have an aspect ratio of at least 1.5, preferably at least 4, and more preferably at least 6. The nanowires may have an aspect ratio of up to 100, preferably up to 50, and more preferably up to 20. Thus, the nanowires may have an aspect ratio of from 1.5 to 100, preferably from 4 to 50, and more preferably from 6 to 20.

It will be appreciated that that the aspect ratios referred to above represent the minimum and maximum aspect ratios observed in the nanowires, *i.e*. an aspect ratio of from A to B means that the minimum aspect ratio observed in the nanowires is at least A and the maximum aspect ratio observed is up to B. The aspect ratio of the nanowires may be measured using scanning electron microscopy. Specifically, scanning electron microscopy may be used to generate images of the nanowires, with the aspect ratio preferably determined using a computer program.

The nanowires are preferably substantially vertically aligned. The alignment of the nanowires may be determined using scanning electron microscopy.

The nanowires may be functionalised, *i.e*. the chemical nature of the nanowire altered. For instance, the surface of the nanowires may be functionalised. For instance, the surface of the nanowires may be functionalised. The nanowires may be functionalised with a binder, a catalyst, a reagent or any other species which enhances the sensory, *e.g.* piezoresistive or piezoelectric, response of the electronic skin when it comes into contact with a target species. The magnitude of the sensory response may indicate the concentration of target species.

For instance, the nanowires may be functionalised with a functional group. A wide range of functional groups may be used, and suitable functional groups will be dependent on both the material of nanowire and the target species. Suitable functional groups include amino (-NH₂), hydroxy (-OH), carboxy (-COOH), amido (-CONH₂) and sulfanyl (-SH) groups. Preferably, the functional group is selected from amino (-NH₂), hydroxy (-OH) and sulfanyl (-SH) groups. These functional groups are useful as binders for target species. As shown in the examples, in a specific embodiment, the nanowire may be functionalised with amino groups for the detection of a protein target species, such as BSA (bovine serum albumin).

Where the nanowire is functionalised with a catalyst, this may cleave a target species into sub-sections, with one of the sub-sections inducing a sensory response in the electronic skin.

It will be appreciated that the nanowire may be functionalised in more than one way, *e.g.* with a catalyst which cleaves a target species into sub-sections, and a binder which encourages binding of a sub-section to the nanowire.

Typically, where the nanowires are functionalised, the active portion of the first conductive layer will also be functionalised.

The sensory response provided by the nanowires is preferably transmitted through a pair of electrical contacts. As mentioned above, the pair of electrical contacts may be provided as part of the first conductive layer to which the first end of each nanowire is preferably tethered.

However, in some embodiments, the substrate of the present invention comprises a third conductive layer to which the second end of each nanowire is preferably tethered. It will be appreciated that second conductive layers do not have to be present in the substrates of the present invention for a third conductive layer to be present. The third conductive layer preferably has a structure and thickness as described in connection with the first conductive layer.

The third conductive layer preferably comprises an active portion to which the second end of each nanowire is preferably tethered. An electrical contact is attached to the third conductive layer. Thus, the sensory, *e.g*. piezoelectric, response of the nanowires may be transmitted through a pair of electrical contacts, one of which is attached to the first conductive layer and the other of which is attached to the third conductive layer. This enables the sensory response across the length of the nanowires to be measured. The third conductive layer preferably comprises the electrical contact, though it may also be present in a different layer of the substrate.

The first conductive layer and the third conductive layer may be attached to one another by a third adhesive layer or, preferably, by multiple (*e.g*. two) third adhesive layers between which a third intermediate polymer layer is disposed.

The third adhesive layers(s) is preferably as described in connection with the first or second adhesive layers. The third adhesive layer(s) may be made from the same material as the first and/or second adhesive layers. The third intermediate polymer layer is preferably as described in connection with the first or second intermediate polymer layer and, in some instances, may be made from the same material as the first and/or second intermediate polymer layer.

### Substrate surface

In some embodiments, a conductive layer (*i.e.* the first conductive layer or, where present, the third conductive layer) may form the outer surface of the substrate. Thus, the first conductive layer and nanowires may be fully exposed to the environment or, where present, the third conductive layer may be fully exposed to the environment.

In other embodiments, one or more further layers are present on the surface of the conductive layer. It will be appreciated, that where just a first conductive layer is used, the one or more further layers will be present on the first conductive layer. However, where a third conductive layer is used, then the one or more further layers will be present on the third conductive layer. An upper polymer layer may be present on the surface of the first or, where present, third conductive layer. The upper polymer layer serves to protect the conductive layer from physical damage as well as chemical contaminants.

The upper polymer may cover the whole surface of the substrate. However, it may also be desirable for portions of the substrate to remain uncovered. For instance, the electrical contacts may be uncovered. Where just a first conductive layer is used, the active portion of the conductive layer may be uncovered, particularly where it has been functionalised. The nanowires may be uncovered, for instance the tips of the nanowires may extend beyond the surface of the upper polymer.

The upper polymer layer may comprise a wide range of upper polymers, depending on the intended use of the electronic skin. The upper polymer is preferably an elastomer.

The upper polymer is preferably selected from polysiloxanes, polyimides, polybutyrates, polymethyl methacrylates, polyacrylic acids, polyethylenes *e.g.* high density polyethylenes and low density polyethylenes, polyethylene terephthalates, polyurethanes including thermoplastic polyurethanes, polyvinyl chlorides, polyethylenimines, polyethylene naphthalates, polypropylenes, polystyrenes, polyamides including aliphatic or semi-aromatic polyamides, a polytetrafluoroethylenes, and polyvinylidene difluorides).

Preferred upper polymers include polysiloxanes, polyimides, polybutyrates, polymethyl methacrylates, polyethylenes *e.g*. high density polyethylene and low density polyethylene, polyethylene terephthalates, polyvinyl chlorides, polyethylenimines, polyethylene naphthalates, and polypropylenes. These polymers are particularly suitable for forming an upper polymer layer which is highly flexible. Particularly preferred are polysiloxanes and polyimides.

Preferred polysiloxanes have the structure: 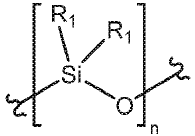 where: each R₁ is independently selected from hydrogen, alkyl and phenyl groups, preferably from hydrogen and C₁₋₆ alkyl groups, more preferably from hydrogen, methyl (*i.e*. -CH₃), ethyl (*i.e*. -CH₂CH₃) and propyl (*i.e*. -CH₂CH₂CH₃ or -CH(CH₃)CH₃), still more preferably from hydrogen and methyl.

It will be appreciated that a variety of siloxane monomers may be used in the polysiloxane or, in other words, the R₁ groups may differ between the monomers making up the polysiloxane.

Preferred polysiloxanes comprise at least 50 molar %, preferably at least 80 molar %, and more preferably at least 85 molar % of monomers in which each R₁ is methyl. Preferably, the polysiloxane is a polydimethylsiloxane.

Polyimides may take a range of structures provided that the imide monomers from which the polymer is prepared include the imide (*i.e.* -C(O)-NR-C(O)-) functional group. Preferred polyimides include poly(4,4'-oxydiphenylene-pyromellitimide) or, more preferably, a structure selected from: 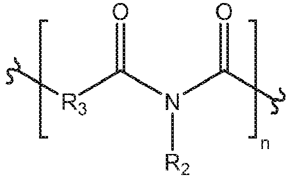 where:
R₁ is an alkyl group, preferably a C₁₋₆ alkyl groups, more preferably is methyl (*i.e.* -CH₃), ethyl (*i.e.* -CH₂CH₃) or propyl (*i.e.* -CH₂CH₂CH₃ or -CH(CH₃)CH₃), and most preferably is methyl, and
R₃ is an alkanediyl group, preferably a C₁₋₆ alkanediyl (*i.e*. alkanediyl) group, more preferably is methanediyl (*i.e.* -CH₂-), ethanediyl (*i.e.* -CH₂CH₂-) or propanediyl (*i.e.* -CH₂CH₂CH₂- or -CH(CH₃)CH₂-), and most preferably is methanediyl.

Polysiloxanes are preferably used as the upper polymer, as these materials are flexible, stretchable and bendable making them highly robust in a wide range of applications.

The upper polymer may be made up of a blend of upper polymers, for instance a blend of the upper polymers listed above, though preferably it will consist of a single polymer such as a polysiloxane.

The upper polymer preferably has a Young's modulus which is lower than that of the base polymer. Since the structural integrity of the substrate is provided by the base polymer, it is desirable to keep the upper polymer layer highly flexible. The upper polymer may have a Young's modulus which is at least 50 kPa, preferably at least 100 kPa and more preferably at least 200 kPa lower than that of the base polymer.

The upper polymer may have a Young's modulus of up to 5 MPa, preferably up to 3 MPa, and more preferably up to 1 MPa. The upper polymer may have a Young's modulus of at least 100 kPa, preferably at least 200 kPa and more preferably at least 300 kPa. Thus, the upper polymer may have a Young's modulus of from 100 kPa to 5 MPa, preferably from 200 kPa to 3 MPa, and more preferably from 300 kPa to 1 MPa.

The upper polymer may have a number average molecular weight of at least 7,500 Da, preferably at least 15,000 Da, and more preferably at least 20,000 Da. The upper polymer may have a number average molecular weight of up to 200,000 Da, preferably up to 150,000 Da, and more preferably up to 100,000 Da. Thus, the upper polymer may have a number average molecular weight of from 7,500 to 200,000 Da, preferably from 15,000 to 150,000 Da, and more preferably from 20,000 to 100,000 Da. Polymers having these molecular weights will typically exhibit preferred levels of elasticity.

It will be appreciated that the upper polymers will typically be electrical insulators, e.g. they will meet the requirements of ASTM D5213-12.

The upper polymer layer may comprise the upper polymer in an amount of at least 75 %, preferably at least 80 %, and more preferably at least 85 %, by weight. Preferably, the upper polymer layer comprises a cross-linking agent. A wide range of cross-linking agents may be used, with siloxanes such as methyl hydrogen siloxane preferred. The cross-linking agent may be present in the upper polymer layer in an amount of up to 15 %, and preferably up to 10 %, by weight. Other components that may be present in the upper polymer layer include dyes.

The upper polymer layer preferably has a thickness which is less than that of the base polymer layer. The upper polymer layer may have a thickness which is up to 0.5, preferably up to 0.25, and more preferably up to 0.15, times the thickness of the base polymer layer.

The upper polymer layer may have a thickness of up to 200 µm, preferably up to 10 µm, and more preferably up to 25 µm. The upper polymer layer may have a thickness of at least 100 nm, preferably at least 500 nm and more preferably at least 1 µm. Thus, the upper polymer layer may have a thickness of from 100 nm to 100 µm, preferably from 500 nm to 50 µm, and more preferably from 1 µm to 20 µm. Upper polymer layers of this thickness have minimal impact on the flexibility of the substrate or, crucially, the sensory response of the conductive layer to its environment, whilst providing a protective barrier to the conductive layer. That said, where a highly durable upper polymer layer may be desirable, the upper polymer layer may have a thickness of greater than 200 µm, *e.g*. from 200 µm to 1 mm.

It will be appreciated that that the thicknesses referred to above represent the minimum and maximum thicknesses observed in the upper polymer layer, *i.e*. a thickness of from A to B means that the minimum thickness of the layer is at least A and the maximum thickness of the layer is up to B. The thickness of the upper polymer layer may be measured using scanning electron microscopy. Specifically, scanning electron microscopy may be used to generate images of the upper polymer layer, with the thickness preferably determined using a computer program.

The upper polymer layer is preferably joined directly to the conductive layer, *i.e*. without any intermediate adhesive, polymer or other layers. Plasma bonding, and preferably oxygen plasma bonding, may be used to improve the adhesion of the upper polymer layer to the conductive layer. Since the upper polymer layer provides a protective rather than structural function, then it is not necessary to provide as high a level of adhesion between the conductive layer and the upper polymer layer as is achieved between the conductive layer and the rest of the substrate.

Nevertheless, where high levels of adhesion are desired, the conductive layer may be joined to the upper polymer layer by a fourth adhesive layer or, though less preferred, by multiple (*e.g*. two) fourth adhesive layers between which a fourth intermediate polymer layer is disposed.

The fourth adhesive layer(s) are preferably as described in connection with the first or second adhesive layers. The fourth adhesive layer(s) may be made from the same material as the first and/or second adhesive layers. The fourth intermediate polymer layer is preferably as described in connection with the first or second intermediate polymer layers and, in some instances, may be made from the same material as the first and/or second intermediate polymer layer. It will be appreciated that third adhesive and/or polymer layers do not have to be present in the substrates of the present invention for fourth adhesive and/or polymer layers to be present.

One or more further layers may be joined to the upper polymer layer, though the upper polymer layer will typically form the outer surface of the substrate. In some embodiments, the substrate may comprise a further polymer layer which is attached to the upper polymer layer, *e.g*. using plasma bonding and preferably oxygen plasma bonding.

The outer surface of the substrate - be it the upper polymer layer or any other layer - may be textured, *e.g*. with ridges, bumps or other surface indentations or protrusions. A textured outer surface may be desirable for a number of reasons. For instance, the outer surface of the substrate may be textured to improve the grip of the electronic skin. In preferred embodiments, texturing is provided on a further polymer layer which is attached to the upper polymer layer.

### Electronic skin

The substrate is preferably used in an electronic skin. Thus, the present invention provides an electronic skin comprising a substrate as defined herein.

When the electronic skin is in use, the conductive layer is electrically connected to a signal receiver, such as a computer. Thus, in some embodiments, the electronic skin comprises electrical connection means which are suitable for electrically connecting the conductive layer, e.g. via the electrical contacts, to the signal receiver.

Suitable electrical connection means include wires or preferably, particularly where a plurality of discrete conductive portions are present, a flex circuit such as a flexible printed circuit. A plug and play slot may also be used.

The electrical connection means may be joined to the substrate by bonding (*e.g*. epoxy bonding for instance using a conductive silver epoxy), by clamping, or by any other means.

The electronic skin preferably comprises a support to which the substrate is attached. Preferably, the electronic skin comprises a plurality of substrates as defined herein attached to the support, for instance at least 2, preferably at least 4, and more preferably at least 6 substrates.

The support may comprise a wide range of materials, such as plastic or textile materials. The substrate may be attached to the support using known methods, for instance by glue or by stitching.

### Methods of manufacture

The substrates of the present invention may be prepared using a number of different methods. Preferably, the substrates are prepared by a method which comprises:
(iv) applying a first conductive layer to a second adhesive layer of an intermediate substrate, and
(v) forming nanowires on the first conductive layer,

wherein the intermediate substrate comprises:
   a base polymer layer,
   a first intermediate polymer layer attached to the base polymer layer by a first adhesive layer, and
   on the surface of the first intermediate polymer layer, a second adhesive layer or multiple second adhesive layers between which a second intermediate polymer layer
   or a second conductive layer is disposed,
where the layers are as described above.

Preferably, the method further comprises preparing the intermediate substrate by:
(i) coating a polymer base layer with a first adhesive layer, preferably using a self-assembly process,
(ii) applying a first intermediate polymer layer on the first adhesive layer, preferably using chemical vapour deposition polymerisation, and
(iii) coating the first intermediate polymer layer with a second adhesive layer, preferably using a self-assembly process, or with multiple second adhesive layers, preferably using a self-assembly process, between which a second intermediate polymer layer is disposed, preferably using chemical vapour deposition polymerisation, or a second conductive layer is disposed, preferably using lithography.

Typically, steps (i) to (v) will be carried out in order. However, it is also possible to prepare a substrate of the present invention by carrying out steps (i)-(v) in another order, e.g. by carrying out steps (iii) and (iv) before step (ii) and even step (i).

Step (i) of the method involves coating the base polymer layer with the first adhesive layer. Preferably, the first adhesive layer is added to the base polymer layer using a self-assembly process.

Typically, the self-assembly process will comprise placing the first adhesive and the base polymer under vacuum. Under low pressure conditions, the first adhesive vaporises, e.g. from an open container in which it is held, and deposits on the base polymer layer, typically as a self-assembled monolayer. Where the first adhesive contains a head group and end group, the head group will generally bond to the base polymer, leaving the end group free to bond to the first intermediate polymer in step (ii).

The self-assembly process may be carried out at a pressure of up to 10,000 Pa, preferably up to 1,000 Pa, and more preferably up to 100 Pa. The self-assembly process may be carried out at a pressure of at least 1 Pa, preferably at least 10 Pa, and more preferably at least 20 Pa. Thus, the self-assembly process may be carried out at a pressure of from 1 to 10,000 Pa, preferably from 10 Pa to 1,000 Pa, and more preferably from 20 to 100 Pa.

The self-assembly process may be carried out at a temperature of at least 5 °C, preferably at least 10 °C, and more preferably at least 15 °C. The self-assembly process may be carried out at a temperature of up to 100 °C, preferably up to 60 °C, and more preferably up to 40 °C. Thus, the self-assembly process may be carried out at a temperature of from 5 to 100 °C, preferably from 10 to 60 °C, and more preferably from 15 to 40 °C.

The self-assembly process may be carried out for a period of from 10 minutes to 5 hours.

The process may be carried out in a desiccator.

Step (ii) of the method involves applying the first intermediate polymer layer on the first adhesive layer. Preferably, the first intermediate polymer layer is applied to the first adhesive layer using a chemical vapour deposition polymerisation process. By using chemical vapour deposition polymerisation, a thin film of the first intermediate polymer may be applied to the first adhesive layer.

Typically, the chemical vapour deposition process will involve vaporising the precursors (*e.g.* monomers) from which the first intermediate polymer is obtained, and depositing the first intermediate polymer layer on the first adhesive layer.

Typically, the vaporisation step will take place under vacuum. The vaporisation step may be carried out at a pressure of up to 10,000 Pa, preferably up to 1,000 Pa, and more preferably up to 200 Pa. The vaporisation step may be carried out at a pressure of at least 10 Pa, preferably at least 20 Pa, and more preferably at least 50 Pa. Thus, the vaporisation step may be carried out at a pressure of from 10 to 10,000 Pa, preferably from 20 Pa to 1,000 Pa, and more preferably from 50 to 200 Pa.

The vaporisation step is preferably carried out at elevated temperatures. The vaporisation step may be carried out at a temperature of at least 50 "C, preferably at least 100 °C, and more preferably at least 120 °C. The vaporisation step may be carried out at a temperature of up to 1,000 °C, preferably up to 800 °C, and more preferably up to 700 °C. Thus, the vaporisation step may be carried out at a temperature of from 50 to 1,000 °C, preferably from 100 to 800 °C, and more preferably from 120 to 700 °C.

In some instances, *e.g.* where the first intermediate polymer is parylene, the vaporisation process may comprise sub-steps in which a *para*-xylylene dimer is vaporised (*e.g*. at a temperature of from 120 to 180 °C) then cleaved (*e.g.* at a temperature of from 630 to 750 °C) to its monomeric form

The deposition step may be carried out under vacuum. The deposition step may be carried out at a pressure of up to 5,000 Pa, preferably up to 500 Pa, and more preferably up to 100 Pa. The deposition step may be carried out at a pressure of at least 0.5 Pa, preferably at least 5 Pa, and more preferably at least 10 Pa. Thus, the deposition step may be carried out at a pressure of from 0.5 to 5,00 Pa, preferably from 5 to 500 Pa, and more preferably from 10 to 100 Pa.

The deposition step may be carried out at a temperature of at least 5 °C, preferably at least 10 °C, and more preferably at least 15 °C. The deposition step may be carried out at a temperature of up to 100 °C, preferably up to 60 °C, and more preferably up to 40 °C. Thus, the deposition step may be carried out at a temperature of from 5 to 100 °C, preferably from 10 to 60 °C, and more preferably from 15 to 40 °C.

Step (iii) of the method involves coating the first intermediate polymer layer with the second adhesive layer. As with the first adhesive layer, the second adhesive layer is preferably added to the first intermediate polymer layer using a self-assembly process.

Typically, the self-assembly process will comprise placing the second adhesive and the first intermediate polymer layer under vacuum. Under low pressure conditions, the second adhesive vaporises, *e.g*. from an open container in which it is held, and deposits on the first intermediate polymer layer, typically as a self-assembled monolayer. Where the second adhesive contains a head group and end group, the head group will generally bond to the first intermediate polymer, leaving the end group free to bond to the first conductive layer in step (iv).

The self-assembly process may be carried out at a pressure of up to 10,000 Pa, preferably up to 1,000 Pa, and more preferably up to 100 Pa. The self-assembly process may be carried out at a pressure of at least 1 Pa, preferably at least 10 Pa, and more preferably at least 20 Pa. Thus, the self-assembly process may be carried out at a pressure of from 1 to 10,000 Pa, preferably from 10 Pa to 1,000 Pa, and more preferably from 20 to 100 Pa.

The self-assembly process may be carried out at a temperature of at least 5 °C, preferably at least 10 °C, and more preferably at least 15 °C. The self-assembly process may be carried out at a temperature of up to 100 °C, preferably up to 60 °C, and more preferably up to 40 °C. Thus, the self-assembly process may be carried out at a temperature of from 5 to 100 °C, preferably from 10 to 60 °C, and more preferably from 15 to 40 °C.

The self-assembly process may be carried out for a period of from 10 minutes to 5 hours.

The process may be carried out in a desiccator.

Where multiple second adhesive layers are used, the method will comprise applying the second intermediate polymer layer or the second conductive layer between the second adhesive layers. Methods for applying the second intermediate polymer layer and the second conductive layer are as described in connection with the first intermediate polymer layer and the first conductive layer, respectively.

Step (iv) of the method involves applying the first conductive layer to a second adhesive layer. Preferably, the first conductive layer is applied to the second adhesive layer using a method selected from sputtering, evaporation deposition, screen-printing, roll-to-roll printing and lithography. It will be appreciated that combinations of these methods may also be used, *e.g*. lithography techniques may be used in which a metallic conductive layer is applied by evaporation deposition. These methods are suitable for applying a thin film of the first conductive material to a second adhesive layer.

In preferred embodiments, the first conductive layer is applied to the second adhesive using lithography, such as photolithography or shadow mask lithography, and more preferably using photolithography.

Typically, the photolithography process will involve applying a photoresist (*e.g*. a negative photoresist) to the second adhesive layer, partially removing the photoresist to give a patterned substrate, depositing the metal layer on the patterned substrate, and removing the remaining photoresist. This produces a substrate in which a first conductive layer covers part of the second adhesive.

The photoresist may be applied to the second adhesive layer using spin coating. Preferably, the second adhesive layer will be subject to oxygen plasma treatment before the photoresist is applied. The photoresist may be cured, *e.g*. by baking.

Partial removal of the photoresist may be achieved by applying light, typically UV light, to the photoresist through a photomask. Once UV treatment is complete, the photoresist may be partially removed using a photoresist developer to give a patterned substrate. The photoresist developer may be selected from silicate salts. Suitable silicate salts include such as an alkali metasilicates such as sodium metasilicate. Preferably, the photoresist developer is free from quaternary ammonium salts, such as tetramethylammonium hydroxide, as these have been found to swell certain substrates such as polysiloxanes.

The first conductive layer may be deposited on the patterned substrate using evaporation deposition, preferably electron-beam physical vapour deposition. In some instances, a first metallic layer may first be applied, followed by a second metallic layer. Preferably, the patterned substrate will be subject to oxygen plasma treatment before the metallic layer is applied.

The remaining photoresist may be removed using a photoresist remover. Suitable photoresist removers include *N*-Methyl-2-pyrrolidone.

Step (v) of the method involves forming nanowires on the first conductive layer. Preferably the nanowires are formed on the first conductive layer using lithography, and preferably using photolithography.

Typically, the process will involve applying a photoresist (*e.g*. a positive photoresist) to the first conductive layer, partially removing the photoresist to give a patterned substrate, forming the nanowires on the patterned substrate, and removing the remaining photoresist. This produces a substrate in which nanowires cover at least part of the first conductive layer.

The photoresist may be applied to the first conductive layer using spin coating. Preferably, the first conductive layer will be subject to oxygen plasma treatment before the photoresist is applied. The photoresist may be cured, e.g. by baking.

Partial removal of the photoresist may be achieved by applying light, typically UV light, to the photoresist through a photomask. Once UV treatment is complete, the photoresist may be partially removed using a photoresist developer to give a patterned substrate. The photoresist developer may be selected from silicate salts. Suitable silicate salts include such as an alkali metasilicates such as sodium metasilicate. Preferably, the photoresist developer is free from quaternary ammonium salts, such as tetramethylammonium hydroxide, as these have been found to swell certain substrates such as polysiloxanes.

The nanowires may be formed on the surface of the first conductive layer by immersion of the conductive layer in a nanowire precursor solution.

Preferably, the first conductive layer is immersed in the nanowire precursor solution at an elevated temperature, *i.e*. in other words the nanowires are grown using hydrothermal synthesis. The first conductive layer may be immersed in the nanowire precursor solution at a temperature of at least 45 °C, preferably at least 55 °C, and more preferably at least 65 °C. The first conductive layer may be immersed in the nanowire precursor solution at a temperature of up to 100 °C, preferably up to 90 °C, and more preferably up to 80 °C. Thus, the first conductive layer may be immersed in the nanowire precursor solution at a temperature of from 45 to 100 °C, preferably from 55 to 90 °C, and more preferably from 65 to 80 °C.

The first conductive layer may be immersed in the nanowire precursor solution for at least 1 hour, preferably at least 1.5 hours, and more preferably at least 2 hours. The first conductive layer may be immersed in the nanowire precursor solution for up to 5 hours, preferably up to 4 hours, and more preferably up to 3 hours. Thus, the first conductive layer may be immersed in the nanowire precursor solution for from 1 to 5 hours, preferably from 1.5 to 4 hours, and more preferably from 2 to 3 hours.

The remaining photoresist may be removed using a photoresist remover. Suitable photoresist removers include *N*-Methyl-2-pyrrolidotie.

Where the substrate comprises a third conductive layer, and third adhesive and third intermediate polymer layers, these may be applied using the methods described in connection with the first conductive layer, the first and second adhesive layers and the first and second intermediate polymer layers.

In some embodiments, pre-formed base polymer layers may be used in the method of preparing the substrates of the present invention. In other embodiments, the method may comprise a step of preparing the base polymer layer. This step will be carried out before step (i).

The base polymer layer may be prepared by mixing the base polymer monomers with any other components that are present in the base polymer, such as a dye and/or a cross-linker, then curing the mixture.

Curing may be carried out at a temperature of at least 20 °C, preferably at least 50 °C, and more preferably at least 70 °C. Curing may be carried out at a temperature of up to 150 °C, preferably up to 120 °C, and more preferably up to 100 °C. Thus, curing may be carried out at a temperature of from 20 to 150 °C, preferably from 50 to 120 °C, and more preferably from 70 to 100 °C. Curing will typically be carried out for 1 to 5 hours, preferably from 2 to 3 hours, though it will be appreciated that longer and shorted curing times may be required when lower and higher curing temperatures, respectively, are used.

The mixture is preferably shaped before it is cured, *e.g*. by pouring it into a mould or preferably by pouring it onto a surface and allowing it to spread under gravity. The mixture, preferably in its shaped form, may be placed in a vacuum oven for degassing before it is cured.

As mentioned above, in some embodiments, one or more further layers, such as an upper polymer layer) are joined to the conductive layer. Thus, the method may comprise a step (vi) of applying one or more further layers on the conductive layer. This step is carried out after step (v), but may be carried out, with steps (iii) to (v), before step (i) or (ii).

An upper polymer layer may be prepared using the method described above in connection with the base polymer layer. However, preferably the upper polymer layer mixture is shaped by spin coating (*e.g*. at a speed of at least 1,000 rpm, preferably at least 3,000 rpm, and more preferably at least 5,000 rpm) onto the conductive layer or, if used, a fourth adhesive layer. This gives a thin-film of the upper polymer layer.

Where the upper polymer layer does not cover the whole surface of the substrate, then areas of the upper polymer layer may be removed by etching, *e.g.* by dry etching (such as reactive ion etching) or by wet etching. Wet etching is preferred, since this can be carried out quicker than dry etching. Typically, the upper polymer layer will be removed from at least the electrical contacts. Where the tips of the nanowires extend beyond the surface of the upper polymer layer, this may be achieved by coating the first conductive layer with an upper polymer layer which is thinner than the nanowires are long.

The outer surface of the substrate, *e.g*. the upper polymer layer, may be textured. Texturing may be introduced after the substrate has been prepared, *e.g*. by etching the surface of the cured upper polymer layer. Alternative, texturing may be introduced during substrate preparation. For instance, the upper polymer layer may be textured by applying a textured mould to the surface of the upper polymer layer during curing.

In some embodiments, the method may comprise joining a further polymer layer, *e.g.* with a textured surface, to the upper polymer layer using oxygen plasma bonding.

The preparation method described above will typically be carried out on a carrier surface, preferably a rigid carried surface. Suitable carrier surfaces include silicon wafers. At the end of the process, the substrate of the present invention is removed from the carrier surface.

Where heating is used in the preparation method, the substrate is preferably left to cool down to room temperature relatively slowly, *e.g*. at a rate of up to 20 °C per minute, preferably up to 10 °C per minute, and more preferably up to 5 °C per minute. This helps to prevent the formation of any defects as a result of thermal shock.

Once prepared, the substrates of the present invention may be used in a method of manufacturing an electronic skin. A method of manufacturing an electronic skin may also comprise preparing a substrate of the present invention, preferably using a method described above.

A method for manufacturing an electronic skin may comprise providing the substrate with electrical connection means. As described above, these electrically connect the conductive layer(s), *e.g*. via the electrical contacts, to a signal receiver, such as a computer. The method may comprise joining the electrical connection means to the substrate by bonding, *e.g*. epoxy bonding such as with a conductive silver epoxy, or by clamping.

A method of manufacturing an electronic skin may further comprise attaching one or more substrates to a support, *e.g*. a support as described above. Suitable methods include gluing and stitching.

The present invention also provides substrates and electronic skins which are obtainable using the methods described above.

### Electronic skin applications

The present invention provides a number of different uses of an electronic skin comprising a substrate of the present invention.

The electronic skins of the present invention may be used as an environmental sensor, *e.g.* as a force sensor or as a chemical sensor. Thus, the present invention provides a method for determining information about an environment, said method comprising:
providing an electronic skin of the present invention; and
measuring chemical or physical conditions in the environment using the electronic skin.

Chemical or physical conditions that may be measured by the electronic skin include force (preferably magnitude of force) to which the electronic skin is subjected, as well as the presence (and preferably concentration) of a chemical species. Chemical species which may be detecting using an electronic skin of the present invention include volatile organic compounds (*i.e.* compounds containing carbon and hydrogen having an initial boiling point less than or equal to 250 °C measured at a standard atmospheric pressure of 101.3 kPa) as well as biomolecules and biomarkers such as proteins.

The electronic skin may be provided on the surface of a subject, *e.g.* a robot or a human, or as part of a device (*e.g.* as part of a wearable, a vehicle, a biosensor). In some embodiments, the chemical or physical conditions identified by the electronic skin may be used to adjust the action (*e.g*. movements, tasks) of the subject or device. The adjustment may be automated or it may be manually controlled by a human.

For instance, the electronic skin may be provided on robotic end-effectors. The action (*e.g*. the grip or location of the end effector) of a robot may then be adjusted based on a force or chemical sensed by the electronic skin. This enables a robot to carry out dextrous jobs.

The electronic skin may also be provided on the feet or underside of a robot. The action (*e.g.* movement or gait) of the robot traversing a surface may then be monitored or adjusted based on the force sensed by the electronic skin.

A robot may be instructed to carry out a task, *e.g*. maintenance or repair of a surface, based on a force (*e.g*. differential force responses across a plurality of force sensors can highlight a surface defect) or chemical (*e.g.* which can highlight degradation) sensed by an electronic skin. For instance, surfaces on off-shore wind turbines, in particular their blades, may be inspected, maintained and repaired using a drone to which an electronic skin of the present invention is attached.

The electronic skin may be provided on the surface of a wearable, such as a prosthetic limb. The electronic skin may be embedded in the surface of the wearable or it may be applied as part of a sleeve or sock which covers the wearable. The force to which the electronic skin is subjected may be used to train an amputee in how to use a prosthetic limb, or it may be used to adjust the design of the prosthetic limb (*e.g.* by enhancing comfort or reducing the effort required for movement).

The electronic skin may be integrated into vehicles, such as cars. For instance, the electronic skin may be used in a steering wheel to indirectly detect if the driver is sleepy, *e.g*. by monitoring the force exerted on the steering wheel. If the forces detected by the electronic skin indicate that the driver is sleep or has fallen asleep, the car may enter an automated control mode. The electronic skin may be used in tyres, *e.g*. to monitor force as an indicator of road conditions. The suspension system (*e.g*. height, spring) or drive mode of the vehicle may then be adjusted, preferably automatically, to suit the road conditions.

The electronic skin may be used in a biosensor to detect biomolecules, such as proteins, in a fluid. The electronic skin may also be used as part of a drug delivery device. In the drug delivery device, the electronic skin measures the concentration of a biomarker in a bodily fluid (typically the blood stream) and, if a target concentration is reached, a therapeutic agent is delivered to the subject, *e.g*. using nano-needles. This may be particularly useful for delivering insulin to a patient suffering from diabetes.

It will be appreciated that the electronic skin may be used in a wide variety of other devices and methods in which a sensory response is desirable.

The invention will now be illustrated with the following non-limiting examples.

### Examples

### Example 1: preparation of a substrate for use in an electronic skin

An substrate was prepared by a method which comprises the following steps:
(i) coating the polydimethylsiloxane base layer with a 3-mercaptopropyl trimethoxysilane first adhesive, and
(ii) applying the parylene intermediate layer on the first adhesive,
(iii) coating the intermediate polymer layer with a 3-mercaptopropyl trimethoxysilane second adhesive,
(iv) applying the zinc first conductive layer to the 3-mercaptopropyl trimethoxysilane second adhesive layer,
(v) forming nanowires on the zinc first conductive layer, and
(vi) applying the polydimethylsiloxane upper polymer layer on the zinc first conductive layer

The polydimethylsiloxane base layer was prepared by combining, in a 10:1 ratio, a polydimethylsiloxane elastomer and a cross-linking agent (methyl hydrogen siloxane). Silicone dye (Sile-Pig, Yellow) was added in an amount of 1 % by weight, and the mixture stirred using a magnetic stirrer at a speed of 700 rpm for 30 minutes. The uncured dyed polydimethylsiloxane system was poured to the brink into a circular disk having a diameter of 3" (7.62 centimetres) and a depth of 500 µm, and left to rest for 10 to 30 minutes. The circular disc was transferred to a vacuum oven for 1 to 3 hours for degassing to take place. Following the degassing process, the polydimethylsiloxane was cured by heating it at 80 °C for 2 to 3 hours. Before removing the polydimethylsiloxane substrate, the oven was left to cool down to 25 °C or below, to prevent the polydimethylsiloxane substrate from undergoing thermal shock. The cured polydimethylsiloxane substrate was withdrawn from the circular disk using a scalpel and placed on a silicon carrier wafer coated with self-assembled monolayer of trichloro(1H, 1H,2H,2H-perfluorooctyl)silane, which acts as an anti-sticking layer. It will be appreciated that the base polymer layer substrate is depicted as rectangular in the figures.

### Step (i)

Deposition of the first adhesive, 3-mercaptopropyl trimethoxysilane, was carried out by placing the polydimethylsiloxane base polymer layer and a beaker containing 3 mL of 3-mercaptopropyl trimethoxysilane solution in a desiccator. The desiccator was kept in a vacuum at a pressure of 40 Pa for 2.5 hours. A self-assembled monolayer of 3-mercaptopropyl trimethoxysilane formed on the surface of the polydimethylsiloxane base polymer layer.

### Step (ii)

After the polydimethylsiloxane substrates had been silanised using 3-mercaptopropyl trimethoxysilane, a parylene-C first intermediate polymer layer having a thickness of 500 nm was deposited on the first adhesive using an SCS Parylene Deposition System.

### Step (iii)

Using the conditions described in step (i), a further layer of 3-mercaptopropyl trimethoxysilane was deposited as the second adhesive on top of the parylene-C first intermediate polymer layer of the substrate from step (ii).

### Step (iv)

Before photolithographic processing, the intermediate substrate produced in step (iii) of Example 1 was kept in an oxygen plasma chamber for 30 seconds, to make the surface of the substrate temporarily hydrophilic. This step also ensured that the photoresist is evenly spread out on the surface of the substrate.

The substrate was placed in a spin coater and 3-4 mL of negative lift-off photoresist (AZnLOF 2035) was poured onto the surface. The substrate was spun at 500 rpm for 10 seconds and then at 1000 rpm for 10 second to give a photoresist thickness of 10 to 12 *µm.* The photoresist was soft baked on a hotplate at 90 °C for 7 to 8 minutes. The substrate was cooled down at the rate of 2 °C /min until the hotplate temperature was 25 °C or below. The substrate was removed from the hotplate and kept on a flat surface to rest for further 5 minutes to ensure that any bubbles trapped within the photoresist were diffused in the surrounding atmosphere.

The photoresist-coated substrate was placed in a UV mask aligner to expose the photoresist through a photomask. A light-field photomask was used in which most of the photomask is transparent except the pattern of interests. Since a negative lift-off photoresist was used, those portions of the photoresist that have not been exposed to UV light are dissolved by the developer solution, to give a photoresist-free area available for the metal deposition. The UV exposure was carried out by using the following parameters: exposure time of 50 seconds; and proximity/contact exposure mode with a proximity distance of 40 µm.

After the UV exposure was completed, the substrate was kept on a flat surface for another 5 to 10 minutes, before being placed in a petri dish filled with developer solution (AZ solution, sodium metasilicate, Na₂SiO₃) for 2.5 to 3 minutes while the petri dish was agitated gently. The substrate was removed from the developer solution, rinsed with deionised water and dried with nitrogen gas, before being left on a flat surface to dry in air for at least 6 hours to ensure that any solvent absorbed by the polydimethylsiloxane is evaporated.

After the patterning of the photoresist layer, the substrate was exposed to oxygen plasma for 30 seconds, before 10 nm of a titanium adhesion layer followed by 300 nm of zinc was deposited using an e-beam evaporator. The zinc-coated substrate was left on a flat desk to rest for at least 6 hours before starting the lift-off process.

The residual photoresist was removed by immersing the zinc-coated substrate in a photoresist remover (NMP-1165, N-methyl-2-pyrrolidone) for 3 to 6 hours, thereby patterning the zinc first conductive layer on top of the substrate. The substrate was left on a flat surface to dry and evaporate any absorbed solvent for 12 hours.

### Step (v)

Photoresist was spin-coated on top of the zinc-coated substrate using the method described in step (iv) but with a positive photoresist (SPR 220-7) used instead of the negative photoresist. Approximately 12 to 20 µm of positive photoresist was obtained on top of the substrate. Soft baking was performed using the same parameters as described in step (iv).

The photoresist-coated substrate was rested for 40 to 60 minutes before carrying out UV exposure using a mask aligner. A dark field photomask is used, and the only area exposed is the active portion of the zinc coating. The UV exposure was carried out by using the following parameters: exposure time of 50 seconds; and proximity/contact exposure mode with a proximity distance of 40 µm.

After the UV exposure was completed, the substrate was rested for 1 hour, before being placed into developer solution (AZ solution, sodium metasilicate, Na₂SiO₃) for 3 to 4 minutes. After development of the photoresist, the substrate was left in air for 3 to 4 hours.

Synthesis of zinc oxide nanowires was carried out by preparing a nanowire precursor solution. The substrate was floated in the precursor solution with the zinc coating face down at 70 °C for 2.5 hours to allow nanowires to form on its surface. The substrate was rinsed with deionised water, dried with nitrogen gas, and left open in air for 4 hours to ensure that any solution absorbed is evaporated.

### Step (vi)

A polydimethylsiloxane upper polymer layer was deposited on the nanowire coated substrate. The uncured polydimethylsiloxane system was prepared using the process described in Example 1 in relating to the base polymer layer, but with a blue (Sile-Pig, Blue), rather than yellow, silicon dye. Different coloured dyes were used to make it easier to inspect the etching of polydimethylsiloxane visually.

The uncured polydimethylsiloxane system was spin coated onto the substrate using a spin coater at 700 rpm for 30 seconds and then at 6000 rpm for 60 seconds to give an upper polymer layer thickness of about 5 to 6 µm. The polydimethylsiloxane upper polymer was cured by heating it 80 °C for 2 to 3 hours. The oven was left to cool to 25 °C or below before the substrate was removed.

The polydimethylsiloxane layer was etched to uncover the electrical contacts using reactive ion etching under the following conditions: a chamber pressure of 30; and an atmosphere of tetrafluoromethane (CF₄): oxygen (O₂) in the ratio of 3:2. Etching was carried out for 3 to 6 hours.

The remaining photoresist was removed by immersing the polymer-coated substrates in NMP-1165 (N-Methyl-2-pyrrolidone) solution for 15 to 20 minutes. The substrate was rinsed with deionised water and dried in nitrogen gas. The substrate was left open in the air to evaporate any absorbed solvents.

The substrate was removed from the silicon carrier wafer ready for use in an electronic skin.

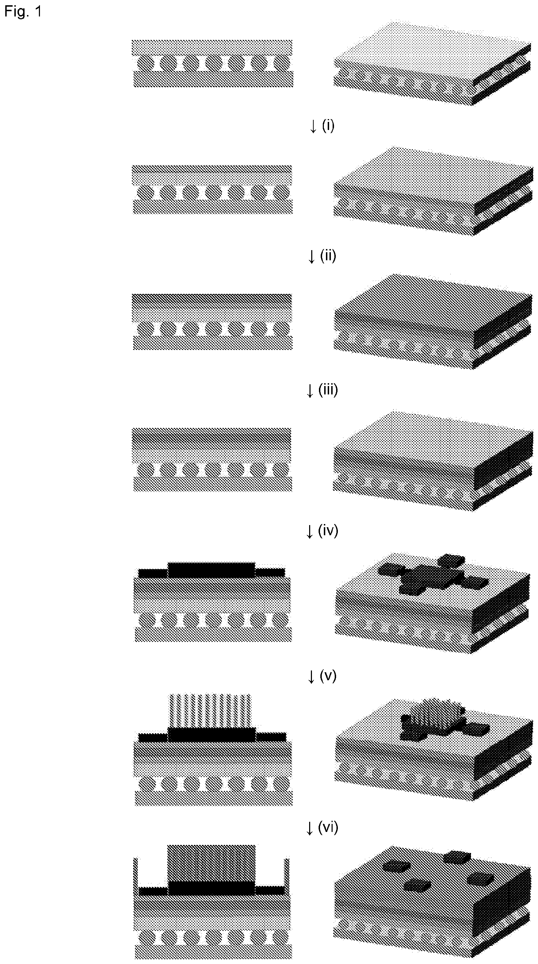

The synthesis method is shown in Fig. 1.

The fabrication process was also used to prepare an electronic skin on other flexible substrates, including on a polyimide (Kapton) base layer.

### Example 2: characterisation of the zinc oxide nanowires

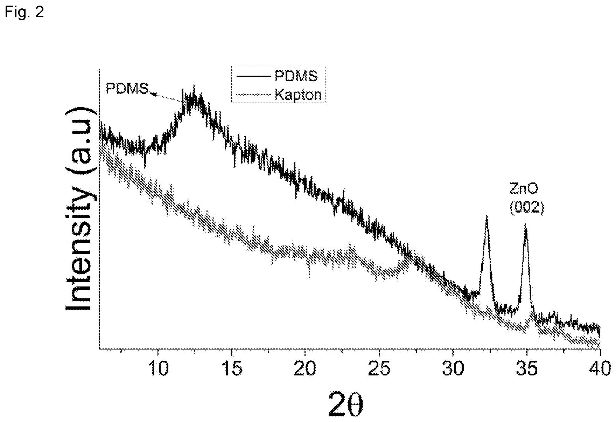

X-ray diffraction was used to analyse the zinc oxide nanowires that were prepared following the procedure of Example 1 and is shown in Fig. 2. A characteristic peak (002) corresponding to single crystalline NWs aligned in the c-direction (*i.e*. vertically) is visible when polydimethylsiloxane and a polyimide are used in the base polymer layer, though the peak is of much greater intensity when polydimethylsiloxane is used.

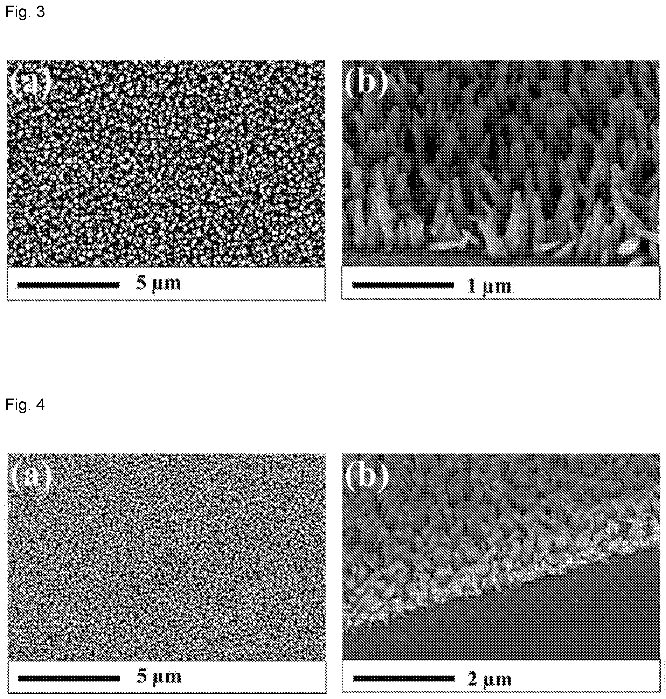

Scanning electron microscope images of the substrates are shown in Fig. 3 (polydimethylsiloxane) and Fig. 4 (polyimide). For each figure, images taken from above, a), and through a cross-section, b), are shown. The zinc oxide nanowires are observable in the images as vertically aligned and densely packed. The aspect ratio is 8 for the nanowires on polydimethylsiloxane, and 2 for the nanowires on the polyimide.

### Example 3: durability tests

The durability of the substrates prepared following the method of Example 1 was tested by subjecting the substrates to a repeated bending test during which the conductivity of the zinc first conductive layer was monitored.

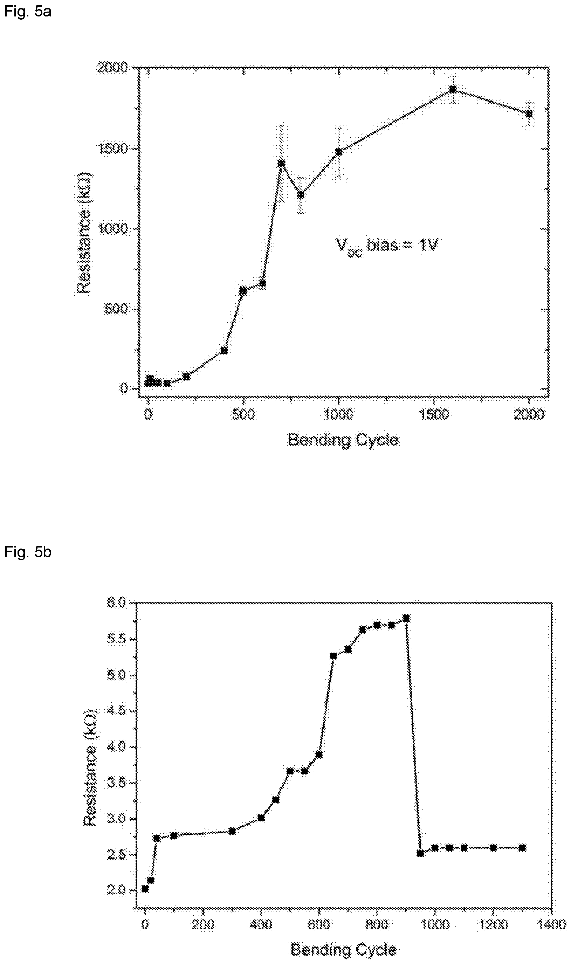

Specifically, the substrates were attached to an electronic bending device using a paperclip. The substrates were subjected to the same cycles of bending at 90° and 180°. During the test, the substrates were bent more than 1,000 times while monitoring the change of resistance. Graphs of the results are shown in Fig. 5a for a substrate with a polydimethylsiloxane base layer and in Fig. 5b for a substrate with a polyimide base layer.

It can be seen that after more than 1,000 bends, the substrates are still conductive thereby showing their durability with use. It can also be seen that the change in resistance of both substrates stabilises with time.

### Example 4: comparison with a substrate lacking an intermediate polymer layer

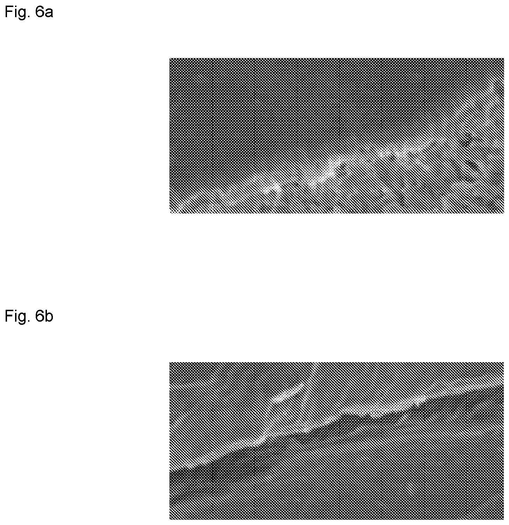

Substrates were prepared with and without an intermediate parylene-C layer and 3-mercaptopropyl trimethoxysilane second adhesive layer. Scanning electron microscopy images of the substrates are shown in Fig. 6.

Where an intermediate parylene-C layer and 3-mercaptopropyl trimethoxysilane second adhesive layer were added, no gap is observed between the polydimethylsiloxane base polymer and an aluminium first conductive layer (see Fig. 6a). However, where an intermediate parylene-C layer and 3-mercaptopropyl trimethoxysilane second adhesive were not used, a small gap can be seen between the polydimethylsiloxane base polymer and the aluminium first conductive layer (see Fig. 6b).

This demonstrates that the combination of an intermediate polymer layer with an adhesive-functionalised surface improves the integrity of the substrate.

### Example 5: comparison with a substrate lacking a second adhesive

Substrates were prepared with and without a 3-mercaptopropyl trimethoxysilane second adhesive layer. Where the 3-mercaptopropyl trimethoxysilane second adhesive layer was not used, a zinc first conductive layer was observed lifting away from the surface of the parylene intermediate layer.

This demonstrates that the use of an adhesive on the surface of the intermediate polymer layer improves the robustness of the substrate.

### Example 6: alternative preparation of a substrate for use in an electronic skin

Steps (i) to (v) were carried out as described in Example 1.

Step (vi) was also carried out as described in Example 1, but the entire upper polymer layer was etched for a period of from 2 to 3 hours to expose the tips of the zinc oxide nanowires.

Three electrical contacts were then selectively etched as described in Example 1; two which are utilised for piezoresistive measurements and one which is utilised for piezoelectric measurements (the other electrical contact being formed as a top electrode).

The following layers were then deposited using the methods described in steps (i) to (iii) of Example 1: 3-mercaptopropyl trimethoxysilane, then parylene-C, then 3-mercaptopropyl trimethoxysilane. The ends of the zinc oxide nanowires extended beyond the surface of the upper 3-mercaptopropyl trimethoxysilane layer.

A layer of zinc, which included a second piezoelectric electrical contact was deposited on top of the nanowires following the photolithography method described in step (iv) of Example 1. A further two upper layers of polydimethylsiloxane were deposited over the top of the zinc, then etched to reveal the contact pads following the method described in step (vi) of Example 1.

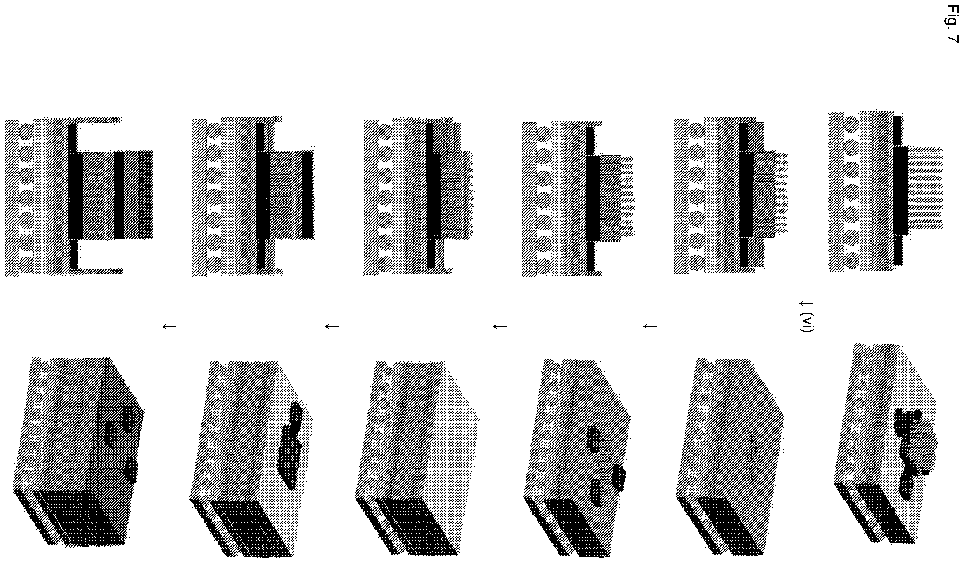

The synthesis method is shown in Fig. 7.

### Example 7: preparation of a substrate for an electronic skin comprising functionalised nanowires

Steps (i) to (v) were carried out as described in Example 1.

The nanowire-covered substrate was introduced into a desiccator in which a beaker containing approximately 2 to 3 mL of 3-aminopropyl trimethoxysilane (APTMS) was held. The substrate was left in the desiccator for 16 hours to functionalise the surface of the nanowires with -NH₂ groups.

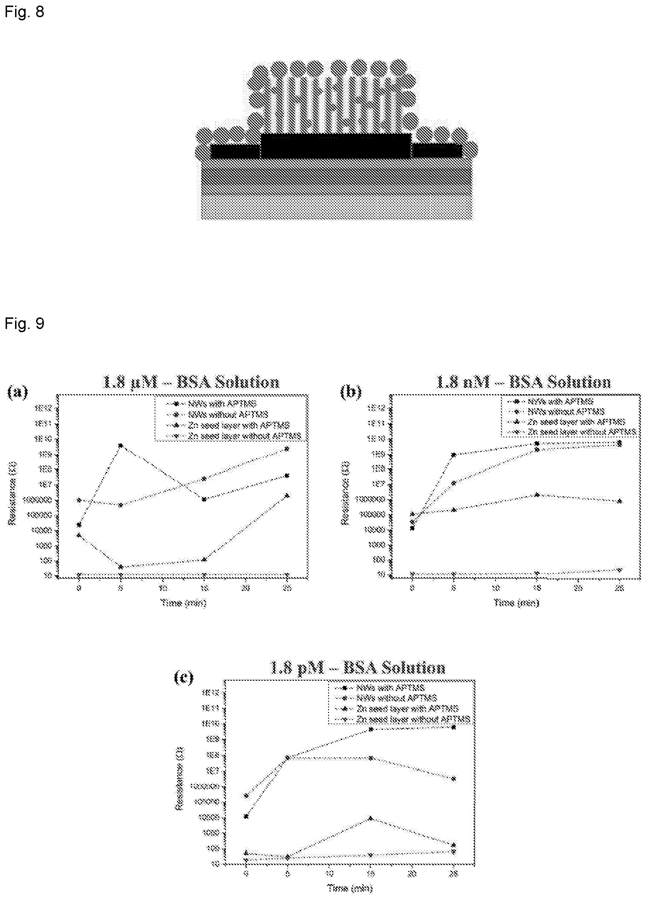

The functionalised substrate is shown in Fig. 8.

### Example 8: use of substrates of the present invention as biosensors

The substrate prepared in Example 7 was immersed in different concentrations of the protein bovine serum albumin (BSA), and the resistance measured at time periods of 5, 10, 15, 20 and 25 minutes. Changes in electrical resistance were caused by physioabsorption of BSA molecules onto the substrate. For comparison, the following substrates were also prepared and tested:
- a substrate with no nanowires and no first conductive layer functionalisation
- a substrate with no nanowires but first conductive layer functionalisation
- a substrate with nanowires but no nanowire functionalisation.

The results from the experiments are shown in Fig. 9. It can be seen that the use of nanowires and functionalisation enhanced the sensory response when the substrates were used as biosensors.

## Claims

1. A substrate for use in an electronic skin, said substrate comprising:
a base polymer layer;
a first intermediate polymer layer attached to the base polymer layer by a first adhesive layer, the first intermediate polymer layer comprising a first intermediate polymer in which electron-rich groups are linked directly to one another or by an optionally substituted C₁₋₄ alkanediyl groups; and
a first conductive layer attached to the first intermediate polymer layer by a second adhesive layer or by multiple second adhesive layers between which a second intermediate polymer layer or a second conductive layer is disposed;
wherein nanowires are present on the first conductive layer.

2. The substrate of Claim 1, wherein the nanowires comprise a material which is piezoelectric.

3. The substrate of Claim 1 or Claim 2, wherein the nanowires comprise a conductive material, and preferably a conductive material that comprises a metal, where the metal in the conductive material is preferably selected from zinc and silver, and more preferably is zinc, *e.g*. in the form of zinc oxide.

4. The substrate of any preceding claim, wherein:
the nanowires extend away from the surface of the first conductive layer;
a first end of the nanowires is tethered to the first conductive layer;
the nanowires have an aspect ratio of from 1.5 to 100, preferably from 4 to 50, and more preferably from 6 to 20; and/or
the nanowires are substantially vertically aligned.

5. The substrate of any preceding claim, wherein the nanowires, *e.g*. the surface of the nanowires, are functionalised with a species which enhances the sensory, *e.g*. piezoresistive or piezoelectric, response of the electronic skin when it comes into contact with a target species, for instance the nanowires are functionalised with a binder, a catalyst or a reagent.

6. The substrate of Claim 5, wherein the nanowires are functionalised with:
a functional group, preferably selected from amino (-NH₂), hydroxy (-OH), carboxy (-COOH), amido (-CONH₂) and sulfanyl (-SH) groups; and/or
a catalyst, the catalyst preferably cleaving a target species into sub-sections, with one of the sub-sections inducing a sensory response in the electronic skin.

7. The substrate of any preceding claim, wherein the substrate comprises a pair of electrical contacts through which a sensory response of the nanowires is transmitted.

8. The substrate of any preceding claim, wherein the substrate comprises a third conductive layer, wherein a first end of the nanowires is tethered to the first conductive layer and a second end of the nanowires is tethered to the third conductive layer.

9. The substrate of Claim 8, wherein a sensory, *e.g*. piezoelectric, response of the nanowires is transmitted through a pair of electrical contacts, one of which is attached to the first conductive layer and the other of which is attached to the third conductive layer.

10. The substrate of Claim 8 or Claim 9, wherein the first and third conductive layers may be attached to one another by a third adhesive layer or, preferably, by multiple (*e.g.* two) third adhesive layers between which a third intermediate polymer layer is disposed.

11. The substrate of any preceding claim, wherein the conductive layer has a thickness of from 10 to 300 nm, preferably from 25 to 200 nm, and more preferably from 50 to 100 nm.

12. An electronic skin comprising one or more substrates as defined in any of Claims 1 to 11 and preferably:
electrical connection means which are suitable for electrically connecting the conductive layer, *e.g.* via the electrical contacts, to a signal receiver *(e.g.* a computer), the electrical connection means being preferably selected from wires, flex circuits and plug and play slots; and/or
a support to which the one or more substrates are attached.

13. A method of preparing a substrate as defined in any of Claims 1 to 11, said method comprising:
(iv) applying a first conductive layer to a second adhesive layer of an intermediate substrate, and
(v) forming nanowires on the first conductive layer,
wherein the intermediate substrate comprises:
a base polymer layer,
a first intermediate polymer layer attached to the base polymer layer by a first adhesive layer, and on the surface of the first intermediate polymer layer, a second adhesive layer or multiple second adhesive layers between which a second intermediate polymer layer or a second conductive layer is disposed,
wherein the method preferably further comprises preparing the intermediate substrate by:
(i) coating a polymer base layer with a first adhesive layer,
(ii) applying a first intermediate polymer layer on the first adhesive layer, and
(iii) coating the first intermediate polymer layer with a second adhesive layer, or with multiple second adhesive layers, between which a second intermediate polymer layer or a second conductive layer is disposed

14. The method of Claim 13, wherein step (v) comprises immersing the first conductive layer in a nanowire precursor solution, preferably at a temperature of from 45 to 100 °C, preferably from 55 to 90 °C, and more preferably from 65 to 80 °C.

15. A method for determining information about an environment, said method comprising:
providing an electronic skin as defined in Claim 12; and
measuring chemical or physical conditions in the environment using the electronic skin, optionally wherein the electronic skin is provided on the surface of a subject or as part of a device, and the chemical or physical conditions identified by the electronic skin are preferably used to adjust the action of the subject or device.

## Patentansprüche

1. Substrat zur Verwendung in einer elektronischen Haut, wobei das genannte Substrat Folgendes umfasst:
eine Basispolymerschicht;
eine erste Zwischenpolymerschicht, die an der Basispolymerschicht durch eine erste Klebstoffschicht befestigt ist, wobei die erste Zwischenpolymerschicht ein erstes Zwischenpolymer umfasst, in dem elektronenreiche Gruppen direkt oder durch optional substituierte C1-4-Alkandiylgruppen miteinander verbunden sind; und
eine erste leitende Schicht, die an der ersten Zwischenpolymerschicht durch eine zweite Klebstoffschicht oder durch mehrere zweite Klebstoffschichten befestigt ist, zwischen denen eine zweite Zwischenpolymerschicht oder eine zweite leitende Schicht angeordnet ist;
wobei Nanodrähte auf der ersten leitenden Schicht vorhanden sind.

2. Substrat nach Anspruch 1, wobei die Nanodrähte ein Material umfassen, das piezoelektrisch ist.

3. Substrat nach Anspruch 1 oder Anspruch 2, wobei die Nanodrähte ein leitendes Material umfassen, und zwar vorzugsweise ein leitendes Material, das ein Metall umfasst, wobei das Metall in dem leitenden Material vorzugsweise aus Zink und Silber ausgewählt ist, und besonders bevorzugt Zink ist, z.B. in Form von Zinkoxid.

4. Substrat nach einem der vorhergehenden Ansprüche, wobei:
die Nanodrähte sich von der Oberfläche der ersten leitenden Schicht weg erstrecken;
ein erstes Ende der Nanodrähte mit der ersten leitenden Schicht verbunden ist;
die Nanodrähte ein Seitenverhältnis von 1,5 bis 100, vorzugsweise von 4 bis 50 und besonders bevorzugt von 6 bis 20 aufweisen; und/oder
die Nanodrähte im Wesentlichen vertikal ausgerichtet sind.

5. Substrat nach einem der vorhergehenden Ansprüche, wobei die Nanodrähte, z.B. die Oberfläche der Nanodrähte, mit einer Spezies funktionalisiert sind, die die sensorische, z.B. piezoresistive oder piezoelektrische, Reaktion der elektronischen Haut verbessert, wenn sie mit einer Zielspezies in Kontakt kommt, z.B. sind die Nanodrähte mit einem Bindemittel, einem Katalysator oder einem Reagenz funktionalisiert.

6. Substrat nach Anspruch 5, wobei die Nanodrähte mit Folgendem funktionalisiert sind:
einer funktionellen Gruppe, vorzugsweise ausgewählt aus Amino- (-NH2), Hydroxy- (-OH), Carboxy- (-COOH), Amido- (-CONH2) und Sulfanyl- (-SH) Gruppen; und/oder
einem Katalysator, wobei der Katalysator vorzugsweise eine Zielspezies in Unterabschnitte spaltet, wobei einer der Unterabschnitte eine sensorische Reaktion in der elektronischen Haut induziert.

7. Substrat nach einem der vorhergehenden Ansprüche, wobei das Substrat ein Paar elektrischer Kontakte umfasst, durch die eine sensorische Reaktion der Nanodrähte übertragen wird.

8. Substrat nach einem der vorhergehenden Ansprüche, wobei das Substrat eine dritte leitende Schicht umfasst, wobei ein erstes Ende der Nanodrähte an der ersten leitenden Schicht und ein zweites Ende der Nanodrähte an der dritten leitenden Schicht befestigt ist.

9. Substrat nach Anspruch 8, wobei eine sensorische, z.B. piezoelektrische, Reaktion der Nanodrähte durch ein Paar elektrischer Kontakte übertragen wird, von denen einer an der ersten leitenden Schicht und der andere an der dritten leitenden Schicht befestigt ist.

10. Substrat nach Anspruch 8 oder Anspruch 9, wobei die erste und die dritte leitende Schicht durch eine dritte Klebstoffschicht oder vorzugsweise durch mehrere (z.B. zwei) dritte Klebstoffschichten, zwischen denen eine dritte Zwischenpolymerschicht angeordnet ist, miteinander verbunden sein können.

11. Substrat nach einem der vorhergehenden Ansprüche, wobei die leitende Schicht eine Dicke von 10 bis 300 nm, vorzugsweise von 25 bis 200 nm und noch bevorzugter von 50 bis 100 nm aufweist.

12. Elektronische Haut, die Folgendes umfasst: ein oder mehrere Substrate wie in einem der Ansprüche 1 bis 11 definiert und vorzugsweise:
ein elektrisches Verbindungsmittel, das geeignet sind, die leitende Schicht, z.B. über die elektrischen Kontakte, mit einem Signalempfänger (z.B. einem Computer) elektrisch zu verbinden, wobei das elektrische Verbindungsmittel vorzugsweise aus Drähten, flexiblen Schaltungen und Plug-and-Play-Steckplätzen ausgewählt ist; und/oder
einen Träger, an dem das eine oder die mehreren Substrate befestigt sind.

13. Verfahren zur Herstellung eines Substrats nach einem der Ansprüche 1 bis 11, wobei das genannte Verfahren folgendes umfasst:
(iv) Aufbringen einer ersten leitenden Schicht auf eine zweite Klebeschicht eines Zwischensubstrats, und
(v) Bilden von Nanodrähten auf der ersten leitenden Schicht,
wobei das Zwischensubstrat Folgendes umfasst:
eine Basispolymerschicht,
eine erste Zwischenpolymerschicht, die durch eine erste Klebeschicht an der Basispolymerschicht befestigt ist, und auf der Oberfläche der ersten Zwischenpolymerschicht eine zweite Klebeschicht oder mehrere zweite Klebeschichten, zwischen denen eine zweite Zwischenpolymerschicht oder eine zweite leitende Schicht angeordnet ist,
wobei das Verfahren vorzugsweise ferner die Herstellung des Zwischensubstrats durch Folgendes umfasst:
(i) Beschichten einer polymeren Basisschicht mit einer ersten Klebstoffschicht,
(ii) Aufbringen einer ersten Zwischenpolymerschicht auf die erste Klebstoffschicht und
(iii) Beschichten der ersten Zwischenpolymerschicht mit einer zweiten Klebeschicht oder mit mehreren zweiten Klebeschichten, zwischen denen eine zweite Zwischenpolymerschicht oder eine zweite leitende Schicht angeordnet ist.

14. Verfahren nach Anspruch 13, wobei Schritt (v) das Eintauchen der ersten leitenden Schicht in eine Nanodraht-Vorläuferlösung umfasst, vorzugsweise bei einer Temperatur von 45 bis 100 °C, vorzugsweise von 55 bis 90 °C und noch bevorzugter von 65 bis 80 °C.

15. Verfahren zum Bestimmen von Informationen über eine Umgebung, wobei das genannte Verfahren Folgendes umfasst:
Bereitstellen einer elektronischen Haut nach Anspruch 12; und
Messen von chemischen oder physikalischen Bedingungen in der Umgebung unter Verwendung der elektronischen Haut, wobei die elektronische Haut optional auf der Oberfläche eines Subjekts oder als Teil einer Vorrichtung bereitgestellt wird und die von der elektronischen Haut identifizierten chemischen oder physikalischen Bedingungen vorzugsweise verwendet werden, um die Wirkung des Subjekts oder der Vorrichtung einzustellen.

## Revendications

1. Substrat destiné à être utilisé dans une peau électronique, ledit substrat comprenant :
une couche de polymère de base ;
une première couche de polymère intermédiaire fixée à la couche de polymère de base par une première couche adhésive, la première couche de polymère intermédiaire comprenant un premier polymère intermédiaire dans lequel les groupes riches en électrons sont liés directement les uns aux autres ou par des groupes alcanediyles en C₁₋₄ éventuellement substitués ; et
une première couche conductrice fixée à la première couche de polymère intermédiaire par une deuxième couche adhésive ou par de multiples secondes couches adhésives entre lesquelles une deuxième couche de polymère intermédiaire ou une deuxième couche conductrice est disposée ;
dans lequel des nanofils sont présents sur la première couche conductrice.

2. Substrat selon la revendication 1, dans lequel les nanofils comprennent un matériau qui est piézoélectrique.

3. Substrat selon la revendication 1 ou la revendication 2, dans lequel les nanofils comprennent un matériau conducteur, et de préférence un matériau conducteur qui comprend un métal, où le métal dans le matériau conducteur est de préférence choisi parmi le zinc et l'argent, et plus préférentiellement est le zinc, par ex. sous forme d'oxyde de zinc.

4. Substrat selon une quelconque revendication précédente, dans lequel :
les nanofils s'étendent à partir de la surface de la première couche conductrice ;
une première extrémité des nanofils est attachée à la première couche conductrice ;
les nanofils ont un rapport d'aspect de 1,5 à 100, de préférence de 4 à 50, et plus préférentiellement de 6 à 20 ; et/ou
les nanofils sont alignés sensiblement verticalement.

5. Substrat selon une quelconque revendication précédente, dans lequel les nanofils, par ex. la surface des nanofils, sont fonctionnalisés avec une espèce qui améliore la sensibilité, par ex. la réponse piézorésistive ou piézoélectrique de la peau électronique lorsqu'elle entre en contact avec une espèce cible, par exemple les nanofils sont fonctionnalisés à l'aide d'un liant, d'un catalyseur ou d'un réactif.

6. Substrat selon la revendication 5, dans lequel les nanofils sont fonctionnalisés avec :
un groupe fonctionnel, de préférence choisi parmi les groupes amino (-NH2), hydroxy (-OH), carboxy (-COOH), amido (-CONH2) et sulfanyl (-SH) ; et/ou
un catalyseur, le catalyseur clivant de préférence une espèce cible en sous-sections, l'une des sous-sections induisant une réponse sensorielle dans la peau électronique.

7. Substrat selon une quelconque revendication précédente, dans lequel le substrat comprend une paire de contacts électriques à travers lesquels une réponse sensorielle des nanofils est transmise.

8. Substrat selon une quelconque revendication précédente, dans lequel le substrat comprend une troisième couche conductrice, dans lequel une première extrémité des nanofils est attachée à la première couche conductrice et une seconde extrémité des nanofils est attachée à la troisième couche conductrice.

9. Substrat selon la revendication 8, dans lequel une réponse sensorielle, par ex. piézoélectrique des nanofils est transmise par l'intermédiaire d'une paire de contacts électriques, dont l'un est fixé à la première couche conductrice et l'autre est fixé à la troisième couche conductrice.

10. Substrat selon la revendication 8 ou la revendication 9, dans lequel les première et troisième couches conductrices peuvent être fixées l'une à l'autre par une troisième couche adhésive ou, de préférence, par de multiples (par ex. deux) troisièmes couches adhésives entre lesquelles est disposée une troisième couche de polymère intermédiaire.

11. Substrat selon une quelconque revendication précédente, dans lequel la couche conductrice a une épaisseur de 10 à 300 nm, de préférence de 25 à 200 nm, et plus préférentiellement de 50 à 100 nm.

12. Peau électronique comprenant un ou plusieurs substrats tels que définis dans l'une des revendications 1 à 11 et de préférence :
des moyens de connexion électrique qui sont conçus pour relier électriquement la couche conductrice, par exemple par l'intermédiaire des contacts électriques, à un récepteur de signaux (par ex. un ordinateur), les moyens de connexion électrique étant de préférence choisis parmi fils, circuits flexibles et fentes "plug and play" ; et/ou
un support auquel sont fixés le ou les substrats.

13. Procédé de préparation d'un substrat tel que défini dans l'une quelconque des revendications 1 à 11, ledit procédé comprenant :
(iv) l'application d'une première couche conductrice sur une deuxième couche adhésive d'un substrat intermédiaire, et
(v) la formation de nanofils sur la première couche conductrice,
dans lequel le substrat intermédiaire comprend :
une couche de polymère de base,
une première couche de polymère intermédiaire fixée à la couche de polymère de base par une première couche adhésive, et sur la surface de la première couche de polymère intermédiaire, une deuxième couche adhésive ou de multiples secondes couches adhésives entre lesquelles est disposée une deuxième couche de polymère intermédiaire ou une deuxième couche conductrice,
dans lequel le procédé comprend en outre de préférence la préparation du substrat intermédiaire en :
(i) revêtant une couche de base en polymère d'une première couche adhésive,
(ii) appliquant une première couche de polymère intermédiaire sur la première couche adhésive, et
(iii) revêtant la première couche de polymère intermédiaire d'une deuxième couche adhésive, ou de multiples deuxièmes couches adhésives, entre lesquelles est disposée une deuxième couche de polymère intermédiaire ou une deuxième couche conductrice.

14. Procédé selon la revendication 13, dans lequel l'étape (v) comprend l'immersion de la première couche conductrice dans une solution de précurseur de nanofils, de préférence à une température comprise entre 45 et 100 °C, de préférence entre 55 et 90 °C, et plus préférentiellement entre 65 et 80 °C.

15. Procédé de détermination d'informations sur un environnement, ledit procédé comprenant :
la fourniture d'une peau électronique tel que définie dans la revendication 12 ; et
la mesure de conditions chimiques ou physiques dans l'environnement à l'aide de la peau électronique, éventuellement dans lequel la peau électronique est placée sur la surface d'un sujet ou fait partie d'un dispositif, et les conditions chimiques ou physiques identifiées par la peau électronique sont de préférence utilisées pour ajuster l'action du sujet ou du dispositif.
